(19) Europäisches Patentamt / European Patent Office / Office européen des brevets

(11) **EP 4 131 675 A1**

(12) **EUROPEAN PATENT APPLICATION**
published in accordance with Art. 153(4) EPC

(43) Date of publication:
**08.02.2023 Bulletin 2023/06**

(21) Application number: **21781520.8**

(22) Date of filing: **30.03.2021**

(51) International Patent Classification (IPC):
**H01S 5/18** (2000.01)

(52) Cooperative Patent Classification (CPC):
**H01S 5/18**

(86) International application number:
**PCT/JP2021/013620**

(87) International publication number:
**WO 2021/200994 (07.10.2021 Gazette 2021/40)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **31.03.2020 JP 2020065047**

(71) Applicant: **Kyoto University**
**Kyoto-shi, Kyoto 606-8501 (JP)**

(72) Inventors:
• **NODA, Susumu**
  **Kyoto-shi, Kyoto 606-8501 (JP)**
• **YOSHIDA, Masahiro**
  **Kyoto-shi, Kyoto 606-8501 (JP)**
• **DE ZOYSA, Menaka**
  **Kyoto-shi, Kyoto 606-8501 (JP)**
• **ISHIZAKI, Kenji**
  **Kyoto-shi, Kyoto 606-8501 (JP)**

(74) Representative: **Hoeger, Stellrecht & Partner**
**Patentanwälte mbB**
**Uhlandstrasse 14c**
**70182 Stuttgart (DE)**

(54) **TWO-DIMENSIONAL PHOTONIC CRYSTAL LASER**

(57)     Provided is a two-dimensional photonic-crystal laser capable of scanning with a laser beam and emitting the laser beam without the laser beam being attenuated by an electrode. A two-dimensional photonic-crystal laser 1 formed by sandwiching, between a first electrode 181 and a second electrode 182, a layered body 10 including an active layer 13 and a two-dimensional photonic-crystal layer 15 in which modified refractive index areas 152 having a refractive index different from a refractive index of a plate-shaped base body 151 are periodically arranged two-dimensionally on the base body 151. The first electrode 181 is divided into a plurality of partial electrodes 1811, and the second electrode 182 is a frame-shaped electrode including a frame-shaped portion 1821 made of a conductor, the second electrode 182 having a window portion 1822 which is a space inside the frame-shaped portion 1821 being arranged to face a region enclosing a plurality of the partial electrodes 1811. A lens 19 provided on the side opposite to the layered body 10 of the second electrode 182 in a manner covering the entire window portion 1822 is included.

Fig. 1

**Description**

TECHNICAL FIELD

The present invention relates to a two-dimensional photonic-crystal laser in which a two-dimensional photonic crystal is used for amplifying light.

BACKGROUND ART

A two-dimensional photonic-crystal laser includes an active layer, a two-dimensional photonic-crystal layer, and a pair of electrodes provided so as to sandwich the active layer and the two-dimensional photonic-crystal layer. The active layer generates light within a specific wavelength band upon being supplied with carriers (carrier holes, electrons) from the electrode. The two-dimensional photonic-crystal layer has a configuration including a plate-shaped base body in which modified refractive index areas whose refractive index differs from that of the base body are periodically arranged two-dimensionally. The modified refractive index area is made of a hole (air) formed in the base body or a member different from the material of the base body. Further, in general, a first cladding layer made of a semiconductor is provided between one of the electrodes (first electrode) and the active layer, and a second cladding layer made of a semiconductor is provided between the two-dimensional photonic-crystal layer and the other electrode (second electrode).

In such a two-dimensional photonic-crystal laser, only light having a predetermined wavelength corresponding to a period length of the arrangement of the modified refractive index areas among light generated in the active layer is amplified in the two-dimensional photonic-crystal layer and laser oscillates, and a laser beam is emitted from a surface of the two-dimensional photonic-crystal layer.

Patent Literatures 1 and 2 describe a two-dimensional photonic-crystal laser in which an emission direction of a laser beam is variable (which is hereinafter referred to as "emission direction variable two-dimensional photonic-crystal laser"). Such an emission direction variable two-dimensional photonic-crystal laser can be suitably used as a light source of a laser printer, a laser display or the like where scanning with the laser beam is performed to form characters and figures.

In the emission direction variable two-dimensional photonic-crystal laser described in Patent Literature 1 (hereinafter, referred to as "first conventional example"), the second electrode is divided into a plurality of parts and provided on a surface of the second cladding layer (a surface on the opposite side to the two-dimensional photonic-crystal layer), and a gap is provided between the divided electrodes (individual electrodes are referred to as "partial electrodes"). Further, a lens is provided above a surface of the second cladding layer. The first electrode is provided so as to cover the entire surface (surface on the opposite side to the active layer) of the first cladding layer.

According to the first conventional example, by causing electric current to flow between one or a plurality of adjacent partial electrodes among a plurality of the partial electrodes and the first electrode, the electric current is supplied into a partial region (hereinafter, referred to as "electric current flow region") of the active layer, and light is generated in the electric current flow region. Then, laser oscillation occurs in a region of the two-dimensional photonic-crystal layer corresponding to the electric current flow region, and a laser beam is emitted from the two-dimensional photonic-crystal layer in a direction perpendicular to the layer. The laser beam emitted from the two-dimensional photonic-crystal layer passes through the gap between the partial electrodes, and then condensed by the lens. Here, since the laser beam is refracted at different angles depending on a position where the laser beam enters the lens, the emitting direction of the laser beam emitted to the outside varies depending on a position where the laser beam enters the lens, and further, on the position of the electric current flow region which determines the position where the laser beam enters the lens. For this reason, by changing the position of the electric current flow region by changing the partial electrode to which electric current is supplied, the emitting direction of the laser beam can be changed, and, in this manner, scanning with the laser beam can be performed.

In the emission direction variable two-dimensional photonic-crystal lasers described in Patent Literatures 2 and 3 (second conventional example), in a two-dimensional photonic-crystal layer, a modified refractive index area is arranged at a position shifted from a lattice point of a two-dimensional lattice such as a square lattice or a rectangular lattice. The shift of the position of the modified refractive index area from a lattice point at each lattice point is defined by a parameter called a modulation phase. In one example, a modified refractive index area is shifted by the same distance in directions of different azimuthal angles at each lattice point, and the phase of the azimuthal angle corresponds to the modulation phase. The inside of the two-dimensional photonic-crystal layer is virtually divided into a plurality of oscillation regions, and in the same oscillation region, phase differences of azimuthal angles (phase differences of modulation phases) between adjacent lattice points have the same value, and the phase differences have different values between different oscillation regions. The second electrode is a partial electrode provided one by one corresponding to each of a plurality of oscillation regions. The first electrode is a transparent electrode provided so as to cover the entire surface of the first cladding layer, and a laser beam is emitted from the first electrode side. In the second conventional example, no lens is provided.

According to the second conventional example, by supplying electric current between one of a plurality of partial electrodes and the first electrode, light is generated in the region (electric current flow region) corresponding to the one partial electrode of the active layer, and laser oscillation occurs in the region (oscillation region) of the two-dimensional photonic-crystal layer corresponding to the one partial electrode. A laser beam is emitted in a direction inclined by an inclination angle determined by the modulation phase from the direction perpendicular to the two-dimensional photonic-crystal layer. Therefore, the modulation phase is changed when the oscillation region is changed by changing the partial electrode to which electric current is supplied, and the emitting direction of the laser beam can be changed, and, in this manner, scanning with the laser beam can be performed.

CITATION LIST

PATENT LITERATURE

Patent Literature 1: JP 2005-277219 A
Patent Literature 2: WO 2014/136607 A
Patent Literature 3: US 2016/0248224 A
Patent Literature 4: JP 2008-243962 A

SUMMARY OF INVENTION

TECHNICAL PROBLEM

In the first conventional example, the laser beam is emitted to the outside only between the partial electrodes, and a part of the laser beam is blocked by the partial electrodes. Further, in the second conventional example, the laser beam is emitted to the outside through the transparent electrode, but since transmittance of light of the transparent electrode is generally not 100%, the laser beam is attenuated by the transparent electrode.
An object of the present invention is to provide an emission direction variable two-dimensional photonic-crystal laser capable of emitting a variable direction laser beam and capable of scanning without being attenuated by an electrode.

SOLUTION TO PROBLEM

A first mode of the present invention made to solve the above problem is a two-dimensional photonic-crystal laser formed by sandwiching, between a first electrode and a second electrode, a layered body including an active layer and a two-dimensional photonic-crystal layer in which modified refractive index areas having a refractive index different from a refractive index of a plate-shaped base body are periodically arranged two-dimensionally in the base body, in which

the first electrode is divided into a plurality of partial electrodes, and
the second electrode is a frame-shaped electrode including a frame-shaped portion made of a conductor, the second electrode having a window portion which is a space inside the frame-shaped portion being arranged to face a region enclosing the plurality of partial electrodes,
the two-dimensional photonic-crystal laser including:
a lens provided on a side opposite to the layered body of the second electrode or on a surface of the layered body on the second electrode side in a manner covering the window portion.

In the two-dimensional photonic-crystal laser of the first mode, by causing electric current to flow between one or a plurality of adjacent ones of the plurality of partial electrodes constituting the first electrode (the region where these one or a plurality of adjacent ones of the plurality of partial electrodes exist is referred to as "electric current supplying region") and the second electrode, electric current is supplied to an electric current flow region in the active layer which is a region corresponding to the electric current supplying region, and light is generated in the electric current flow region. By the above, laser oscillation occurs in a region in the two-dimensional photonic-crystal layer corresponding to the electric current flow region, a laser beam is emitted from the two-dimensional photonic-crystal layer in a direction perpendicular to the layer, passes through the window portion of the second electrode and the lens, and is emitted to the outside of the two-dimensional photonic-crystal laser. Here, since the laser beam is refracted at different angles depending on a position where the laser beam enters the lens, the emitting direction of the laser beam emitted to the outside varies depending on the position where the laser beam enters the lens, and further, on the position of the electric current supplying region which determines the position where the laser beam enters the lens. For this reason, by changing a position of the electric current flow region by changing the partial electrode or electrodes to which electric current is supplied, the emitting direction of the laser beam can also be changed, and thus, scanning with the laser beam can be performed.

The lens may be provided on the side opposite to the layered body of the second electrode, or may be provided on a surface of the layered body on the second electrode side. In a case where the lens is provided on a surface of the layered body on the second electrode side, the lens is preferably formed integrally with the layered body. By the above, size of the two-dimensional photonic-crystal laser can be reduced. Such a lens integrated with the layered body can be produced by processing a surface of the layered body on the second electrode side by any method including etching.

The electric current flow region in the active layer does not have the same size as the electric current supplying region in the first electrode. In the present invention, since the window portion of the second electrode is arranged to face the region enclosing a plurality of the partial electrodes, an outer shape of the frame-shaped portion of the second electrode is larger than the electric current supplying region in the first electrode, and thus electric current flows so as to spread in an in-plane direction of the active layer from the first electrode toward the second electrode. For this reason, the electric current flow region is larger than the electric current supplying region.

According to the two-dimensional photonic-crystal laser of the first mode, since the laser beam emitted from the two-dimensional photonic-crystal layer passes through the window portion of the second electrode, that is, the space inside the frame-shaped portion in which no conductor exists, the laser beam is emitted without being attenuated.

In the two-dimensional photonic-crystal laser of the first mode, it is preferable that the interval between adjacent partial electrodes is set such that a partial electric current flow region, which is a region in the active layer where electric current is supplied from one of the plurality of partial electrodes, overlaps a part of the partial electric current flow region in the active layer where electric current is supplied from a partial electrode adjacent to the partial electrode. By the above, one electric current flow region not divided into a plurality of electric current flow regions is formed in the active layer, and light emission from the one electric current flow region is amplified by the two-dimensional photonic-crystal layer. In this manner, a coherent laser beam can be obtained. Overlapping of partial electric current flow regions formed by adjacent partial electrodes in this manner can be realized by performing simulation in which parameters such as the distance between the first electrode (partial electrode) and the active layer, the distance between the active layer and the second electrode, the distance between the partial electrodes, and the area of the second electrode are set appropriately.

In the two-dimensional photonic-crystal laser of the first mode, it is preferable that the lens is placed away from the two-dimensional photonic-crystal layer by a distance 0.5 to 2 times the focal length of the lens. By thus arranging the lens away from the two-dimensional photonic-crystal layer by a distance close to a focal length of the lens, it is possible to suppress an increase in the diameter of the laser beam passing through the lens.

In the two-dimensional photonic-crystal laser of the first mode,

it is preferable that in the two-dimensional photonic-crystal layer,
the modified refractive index area includes two partial modified refractive index areas, and
the shape of the two partial modified refractive index areas is set so that ($|\kappa_{180} - (-\kappa_{90})| = |\kappa_{180} + \kappa_{90}|$), which is the absolute value of the difference between the coupling coefficient $\kappa_{180}$ of 180° diffracted light obtained as light propagating in the two-dimensional photonic-crystal layer is diffracted by the modified refractive index area in the 180° direction and the coupling coefficient $-\kappa_{90}$ of 90° diffracted light obtained as light propagating in the two-dimensional photonic-crystal layer is diffracted by the modified refractive index area in a 90° direction is 100 cm$^{-1}$ or less.

Here, the coupling coefficient is a parameter representing intensity of diffracted light, and may take either positive or negative values. The value $\kappa_{180}$ is a one-dimensional coupling coefficient (Hermitian component) representing an interaction between in-plane guided light guided in one direction and in-plane guided light obtained as a traveling direction of the in-plane guided light is changed by 180° (diffracted by 180°) by being reflected by the modified refractive index area. The value $\kappa_{90}$ is a two-dimensional coupling coefficient representing an interaction between an in-plane guided light guided in one direction and light obtained as a traveling direction of the in-plane guided light is changed by 90° by the modified refractive index area. These $\kappa_{180}$ and $\kappa_{90}$ are obtained on the basis of a shape of the modified refractive index area. As $|\kappa_{180} + \kappa_{90}|$, which is the absolute value of the difference between $\kappa_{180}$ and $-\kappa_{90}$, becomes closer to zero, the intensity of interference light of the 180° diffracted light and the 90° diffracted light becomes weaker, and by this, the effect that light is confined in the two-dimensional photonic-crystal layer is suppressed. For this reason, the intensity of the laser beam emitted to the outside of the two-dimensional photonic-crystal laser can be increased. For this reason, it is preferable that as described above, $|\kappa_{180} + \kappa_{90}|$ is 100 cm$^{-1}$ or less.

It is preferable that the two-dimensional photonic-crystal laser according to the first mode further includes a reflection portion between a plurality of the partial electrodes (in a gap between adjacent partial electrodes), where the reflection portion is made of an electrically insulating material and configured to reflect a laser beam. By the above, a laser beam emitted from the two-dimensional photonic-crystal layer to the first electrode side is reflected by the reflection portion and the partial electrodes and emitted from the window portion of the second electrode, so that light emission efficiency can be improved.

A second mode of the present invention is a two-dimensional photonic-crystal laser formed by sandwiching, between a first electrode and a second electrode, a layered body including an active layer and a two-dimensional photonic-crystal layer in which modified refractive index areas having a refractive index different from a refractive index of a plate-shaped base body are arranged two-dimensionally on the base body, in which

the first electrode is divided into a plurality of partial electrodes,

the second electrode is a frame-shaped electrode including a frame-shaped portion made of a conductor, the second electrode having a window portion which is a space inside the frame-shaped portion being arranged to face a region enclosing the plurality of partial electrodes,

in the two-dimensional photonic-crystal layer, each of the modified refractive index areas is arranged by being modulated by a predetermined modulation phase $\Psi$ at each lattice point of a basic two-dimensional lattice having periodicity determined so as to form a resonance state with a predetermined wavelength by forming a two-dimensional standing wave and not to emit light with the wavelength to outside, and

the modulation phase $\Psi$ is expressed by $\Psi = rT \cdot G'\uparrow$ using a wavevector $kT = (k_x, k_y)$ of light having the wavelength $\lambda_L$ in the two-dimensional photonic-crystal layer, an effective refractive index $n_{eff}$ of the two-dimensional photonic-crystal layer, a predetermined angle $\theta$, a reciprocal lattice vector $G'\uparrow = (g'_x, g'_y) = (kx \pm |k\uparrow|(\sin\theta\cos\phi)/n_{eff}, ky \pm |k\uparrow|(\sin\theta\sin\phi)/n_{eff})$ expressed using an azimuth angle $\phi$ from a predetermined reference line of the basic two-dimensional lattice, and a position vector $r\uparrow$ of each lattice point, and the angle $\theta$ differs depending on a position in the two-dimensional photonic-crystal layer.

In the two-dimensional photonic-crystal laser of the second mode, by causing electric current to flow between one or a plurality of adjacent ones of the plurality of partial electrodes constituting the first electrode (the region where these one or a plurality of adjacent ones of the plurality of partial electrodes exist is referred to as "electric current supplying region" as in the first mode) and the second electrode, electric current is supplied to an electric current flow region which is a region of a part of the active layer, and light is generated in the electric current flow region. By the above, laser oscillation by light of the predetermined wavelength occurs in a region (referred to as "light amplification region") corresponding to the electric current flow region in the two-dimensional photonic-crystal layer, and a laser beam is generated. Here, the predetermined wavelength only needs to be included within a wavelength range of light generated in the active layer.

The laser beam generated in this manner is emitted from the two-dimensional photonic-crystal layer at an inclination angle (an angle formed by a normal line to the two-dimensional photonic-crystal layer and an emitting direction of a laser beam) corresponding to a modulation phase of the two-dimensional photonic-crystal layer in the light amplification region, passes through the window portion of the second electrode, and is emitted to the outside of the two-dimensional photonic-crystal laser. This inclination angle is determined by the modulation phase $\Psi$ at each lattice point in the light amplification region. Then, since the angle $\theta$ defining a modulation phase differs depending on a position in the two-dimensional photonic-crystal layer, the emitting direction of the laser beam can also be changed by changing the position of the electric current flow region by changing the partial electrode to which electric current is supplied. For this reason, scanning with the laser beam can be performed.

Up to this point, description is made assuming that the reciprocal lattice vector $G'\uparrow$ in the modulation phase $\Psi = r\uparrow \cdot G'\uparrow$ does not depend on a position in the two-dimensional photonic-crystal layer, but as described in Patent Literature 3, the reciprocal lattice vector $G'\uparrow$ may be defined as a function $G'(x, y)j$ depending on a position in the two-dimensional photonic-crystal layer. In this case, as described below, the $G'\uparrow(x, y)$ can be defined using an inclination angle $\theta(x, y)$ and an azimuth angle $\phi(x, y)$ of a laser beam to be emitted from a position $(x, y)$ in the two-dimensional photonic-crystal layer (strictly, an "in-plane position" in the two-dimensional photonic-crystal layer), and further, the modulation phase $\Psi(x, y)$ at the position $(x, y)$ can be defined. That is, when angles $\theta_x(x)$ and $\theta_y(y)$ expressed by $\sin\theta_x(x) = \sin\theta(x, y)\cos\phi(x, y)$ and $\sin\theta_y(y) = \sin\theta(x, y)\sin\phi(x, y)$ are defined from the inclination angle $\theta(x, y)$ and the azimuth angle $\phi(x, y)$, the reciprocal lattice vector $G'(x, y)\uparrow$ is expressed by $G'(x, y)\uparrow = (g'_x(x), g'_y(y)) = (k_x \pm |k\uparrow|\sin\theta_x(x)/n_{eff}, k_y \pm |k\uparrow|\sin\theta_y(y)/n_{eff})$. Then the modulation phase $\Psi(x, y)$ is expressed as follows:
[Equation 1]

$$\Psi\left(x,y\right)=\int G'\left(x,y\right)\mathrm{d}x\mathrm{d}y$$

... (1)

The modulation phase Ψ(x, y) is defined by the inclination angle θ(x, y) and the azimuth angle φ(x, y) at the position(x, y).

By arranging each modified refractive index area in the two-dimensional photonic-crystal layer modulated with the modulation phase Ψ(x, y) expressed by Equation (1) at each lattice point of the basic two-dimensional lattice, a laser beam having an inclination angle and an azimuth angle close to the inclination angle θ(x, y) and the azimuth angle φ(x, y) that define a modulation phase of the two-dimensional photonic-crystal layer in the light amplification region can be obtained. In particular, when the modulation phase Ψ(x, y) is defined using the same inclination angle θ(x, y) and azimuth angle φ(x, y) in a certain light amplification region, a laser beam having the inclination angle θ(x, y) and the inclination angle φ(x, y) is obtained from the light amplification region.

According to the two-dimensional photonic-crystal laser of the second mode, since the laser beam emitted from the two-dimensional photonic-crystal layer passes through the window portion of the second electrode, that is, the space inside the frame-shaped portion in which no conductor exists, the laser beam can be emitted without being attenuated.

In the two-dimensional photonic-crystal laser of the second mode, it is possible to employ a configuration in which each of the modified refractive index areas is arranged to be shifted from the lattice point by the same distance at each lattice point, and the modulation phase for each lattice point is set based on the difference in the angle formed by the direction of the shift and a reference line.

Alternatively, in the two-dimensional photonic-crystal laser of the second mode, it is also possible to employ a configuration in which each of the modified refractive index areas is arranged to be shifted from the lattice point in the same direction at each lattice point, and the modulation phase for each lattice point is set based on the difference in the distance of the shift. Here, the direction different from a certain direction by 180° is considered "the same direction" as the certain direction.

As still another example, in the two-dimensional photonic-crystal laser of the second mode, it is also possible to employ a configuration in which each of the modified refractive index areas is arranged at each lattice point, and the modulation phase for each lattice point is set based on the difference in area of each modified refractive index area.

In the two-dimensional photonic-crystal laser of the second mode, like in the first mode, it is preferable that an interval between adjacent partial electrodes is set such that a partial electric current flow region of the active layer, which is the region where electric current is supplied from one of the plurality of partial electrodes, overlaps a part of a partial electric current flow region of the active layer where electric current is supplied from a partial electrode adjacent to the partial electrode.

Further, like in the first mode, it is preferable that the two-dimensional photonic-crystal laser according to the second mode further includes a reflection portion between a plurality of the partial electrodes (in a gap between adjacent partial electrodes), where the reflection portion is made of an electrically insulating material and configured to reflect a laser beam.

ADVANTAGEOUS EFFECTS OF INVENTION

According to the present invention, an emission direction variable two-dimensional photonic-crystal laser capable of emitting a variable direction laser beam and capable of scanning without being attenuated by an electrode can be obtained.

BRIEF DESCRIPTION OF DRAWINGS

Fig. 1 is a schematic configuration diagram illustrating a first embodiment of a two-dimensional photonic-crystal laser according to the present invention.
Fig. 2 is a perspective view illustrating a two-dimensional photonic-crystal layer, a first electrode, and a second electrode included in the two-dimensional photonic-crystal laser of the first embodiment.
Fig. 3 is a plan view illustrating an example of the two-dimensional photonic-crystal layer in the two-dimensional photonic-crystal laser of the first embodiment.
Fig. 4 is a plan view illustrating another example of the two-dimensional photonic-crystal layer in the two-dimensional photonic-crystal laser of the first embodiment.

Fig. 5A is a plan view illustrating an example of a shape and arrangement of a partial electrode constituting the first electrode in the two-dimensional photonic-crystal laser of the first embodiment.

Fig. 5B is a plan view illustrating another example of a shape and arrangement of the partial electrode constituting the first electrode in the two-dimensional photonic-crystal laser of the first embodiment.

Fig. 6A is a diagram illustrating an example of a partial electric current flow region and an electric current flow region when electric current is supplied to an active layer from a plurality of adjacent ones of the partial electrodes in the two-dimensional photonic-crystal laser according to the first embodiment.

Fig. 6B is a diagram illustrating an example in which the electric current flow region is moved as the partial electrode to which electric current is supplied is changed in the two-dimensional photonic-crystal laser according to the first embodiment.

Fig. 7A is a diagram illustrating an example of an emitting direction of a laser beam generated when electric current is supplied to the active layer from a plurality of adjacent ones of the partial electrodes in the two-dimensional photonic-crystal laser according to the first embodiment.

Fig. 7B is a diagram illustrating an example in which a laser beam is moved as the partial electrode to which electric current is supplied is changed, so that the emitting direction of the laser beam that passes through a lens is changed in the two-dimensional photonic-crystal laser according to the first embodiment.

Fig. 8 is a diagram illustrating a relationship between a direction of movement of an electric current flow region and a direction of movement of (scanning with) a laser beam in the two-dimensional photonic-crystal laser according to the first embodiment.

Fig. 9 is a diagram illustrating an example in which a plurality of electric current flow regions are formed in the active layer when electric current is supplied from a plurality of adjacent ones of the partial electrodes in the two-dimensional photonic-crystal laser according to the first embodiment.

Fig. 10A is a diagram for explaining a calculation condition for determining an interval between the partial electrodes in the two-dimensional photonic-crystal laser of the first embodiment.

Fig. 10B is a graph showing a result obtained by calculation of a relationship between the distance w from an end portion of the partial electrode and a ratio $i_1/i_0$ of electric current density for each of cases where a depth d from the partial electrode takes a plurality of values in the two-dimensional photonic-crystal laser according to the first embodiment.

Fig. 10C is a graph showing a relationship between the depth d from the partial electrode and the distance $w_e$ from an end portion of the partial electrode when a ratio $i_1/i_0$ of the electric current density is $1/e^2$ in the two-dimensional photonic-crystal laser of the first embodiment.

Fig. 11 is a diagram illustrating a parameter for obtaining a coupling coefficient representing a state of interference of light in the two-dimensional photonic-crystal layer.

Fig. 12A is a graph showing a result obtained by calculating a difference in the coupling coefficient representing interference between 180° diffracted light and 90° diffracted light due to a difference in distance in an x direction and a y direction between a first partial modified refractive index area and a second partial modified refractive index area.

Fig. 12B is a graph showing a result obtained by calculating a difference in the coupling coefficient representing interference between 180° diffracted light and 90° diffracted light due to a difference in filling rates between the first partial modified refractive index area and the second partial modified refractive index area.

Fig. 12C is a graph showing a result obtained by calculating a difference in the coupling coefficient representing interference between 180° diffracted light and 90° diffracted light due to a difference in differences in flatness between the first partial modified refractive index area and the second partial modified refractive index area.

Fig. 13A is a schematic configuration diagram illustrating a variation of the two-dimensional photonic-crystal laser of the first embodiment.

Fig. 13B is a schematic configuration diagram illustrating another variation of the two-dimensional photonic-crystal laser of the first embodiment.

Fig. 14 is a schematic configuration diagram illustrating a second embodiment of the two-dimensional photonic-crystal laser according to the present invention.

Fig. 15A is a plan view illustrating an example of the two-dimensional photonic-crystal layer in the two-dimensional photonic-crystal laser of the second embodiment.

Fig. 15B is a plan view illustrating a position of the center of gravity of a modified refractive index area in the two-dimensional photonic-crystal layer illustrated in Fig. 15A.

Fig. 16A is a diagram illustrating an example of an emitting direction of a laser beam generated when electric current is supplied to the active layer from a plurality of adjacent ones of the partial electrodes in the two-dimensional photonic-crystal laser according to the second embodiment.

Fig. 16B is a diagram illustrating an example in which a laser beam is moved as the partial electrode to which electric current is supplied is changed, so that the emitting direction of the laser beam is changed in the two-dimensional photonic-crystal laser according to the second embodiment.

Fig. 17 is a plan view illustrating a position of the center of gravity of the modified refractive index area in an example of a configuration having the same shifted azimuth in the same shifted azimuth angle setting region having a plurality of lattice points adjacent in the x direction and having different shifted azimuths between different shifted azimuth angle setting regions, which is a variation of the second embodiment.

Fig. 18 is a plan view illustrating a position of the center of gravity of a modified refractive index area in an example of a configuration in which the distance of the shift in the x direction is modulated by the modulation phase according to a variation of the second embodiment.

Fig. 19 is a plan view illustrating a two-dimensional photonic-crystal layer in an example of a configuration in which an area of a planar shape of the modified refractive index area is modulated by a modulation phase, which is a variation of the second embodiment.

DESCRIPTION OF EMBODIMENTS

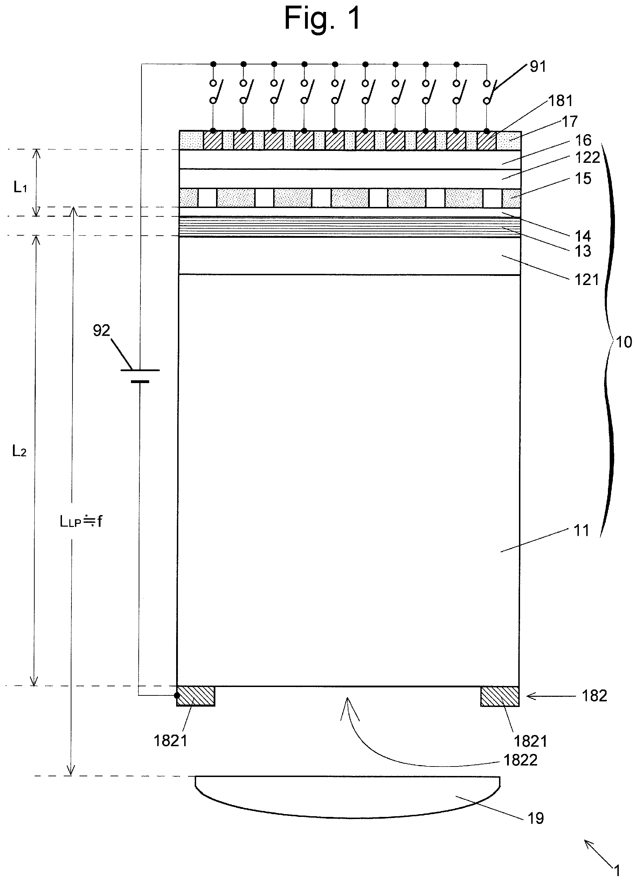

An embodiment of an emission direction variable two-dimensional photonic-crystal laser (hereinafter, simply referred to as "two-dimensional photonic-crystal laser") according to the present invention will be described with reference to Figs. 1 to 19. Hereinafter, for convenience, the terms "upper" and "lower" are used when describing a relative positional relationship of each constituent of the two-dimensional photonic-crystal laser, but these terms do not limit a direction of the two-dimensional photonic-crystal laser.

(a) Two-dimensional photonic-crystal laser of first embodiment

(a-1) Configuration of two-dimensional photonic-crystal laser of first embodiment

As illustrated in Fig. 1, a two-dimensional photonic-crystal laser 1 of a first embodiment has a structure in which a layered body 10 described later is sandwiched between a first electrode 181 and a second electrode 182. Further, a lens 19 is provided on the side of the second electrode 182 opposite to the layered body 10.

The layered body 10 is formed by laminating a substrate 11, a first cladding layer 121, an active layer 13, a carrier block layer 14, a two-dimensional photonic-crystal layer 15, a second cladding layer 122, and a contact layer 16 in this order from the lower side of Fig. 1. The first electrode 181 is provided on an upper surface of the contact layer 16, and the second electrode 182 is provided on a lower surface of the substrate 11.

The active layer 13 generates light emission within a specific emission wavelength band upon being supplied with carrier holes and electrons. For the active layer 13, for example, a multiple-quantum well (MQW) in which a thin film made of indium gallium arsenide (InGaAs) and a thin film made of gallium arsenide (GaAs) are alternately laid in large numbers can be used.

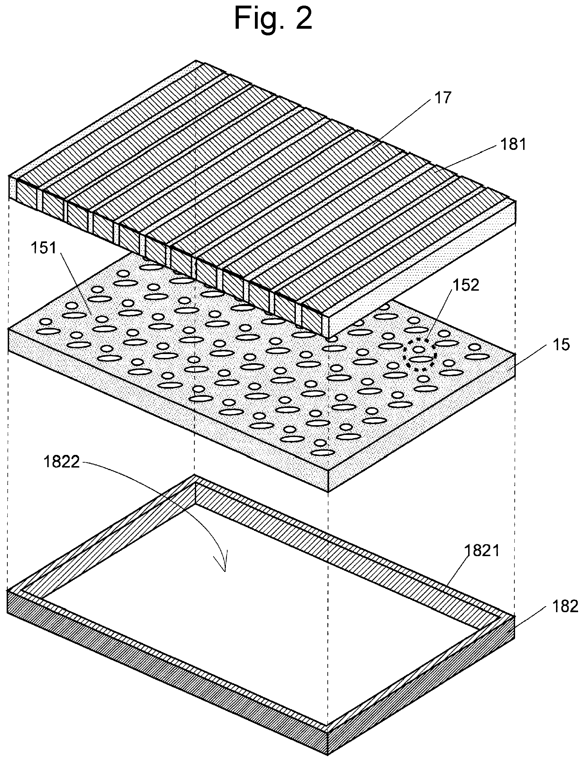

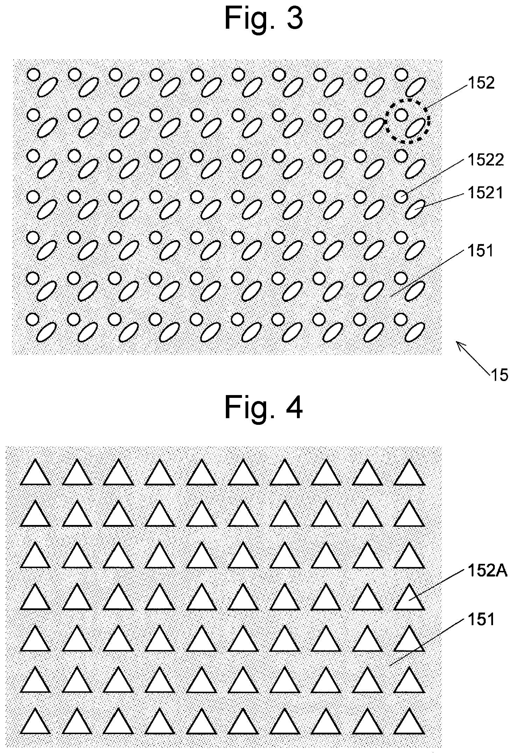

As illustrated in Figs. 2 and 3, in the two-dimensional photonic-crystal layer 15, a modified refractive index area 152 having a refractive index different from that of a plate-shaped base body 151 is periodically arranged two-dimensionally in the base body 151. The modified refractive index area 152 is typically formed by forming a hole (refractive index ≈ 1) in the base body 151. Instead of forming the hole, the modified refractive index area 152 may be formed by embedding a member (modified refractive index member) having a refractive index different from that of the base body 151 in the base body 151.

In the present embodiment, a large number of the modified refractive index areas 152 are arranged in a square lattice pattern in the base body 151. Further, in the present embodiment, one modified refractive index area 152 is formed by combining two partial modified refractive index areas, a first partial modified refractive index area 1521 and a second partial modified refractive index area 1522. The first partial modified refractive index area 1521 has an elliptical shape, and the second partial modified refractive index area 1522 has a circular shape. A major axis of an ellipse of the first partial modified refractive index area 1521 is arranged to face a direction inclined by 45° with respect to a line connecting closest lattice points of the square lattice.

In Fig. 3, for convenience of drawing, only 70 of the modified refractive index areas 152 are drawn, but actually, a larger number of the modified refractive index areas 152 are provided in the two-dimensional photonic-crystal layer 15.

The configuration of the modified refractive index area 152 described here is an example, and each of the modified refractive index areas 152 may include only one hole or modified refractive index member, or may include three or more holes or modified refractive index members. Further, the shape of the modified refractive index area or each partial modified refractive index area is not limited to that in the above example. For example, as illustrated in Fig. 4, a modified refractive index area 152A made of one hole having an equilateral triangular planar shape can be periodically arranged two-dimensionally. By using a modified refractive index area having a non-circular planar shape like an equilateral triangle, it is possible to suppress disappearance of light from due to interference in a two-dimensional photonic-crystal. The modified refractive index area 152 made of the first partial modified refractive index area 1521 and the second partial modified refractive index area 1522 illustrated in Figs. 2 and 3 also has a non-circular planar shape as a whole, so that it is possible to suppress disappearance of light due to interference.

Usually, the substrate 11 and the first cladding layer 121 are made of an n-type semiconductor, and the carrier block layer 14, the base body 151 of the two-dimensional photonic-crystal layer 15, the second cladding layer 122, and the contact layer 16 are made of a p-type semiconductor. By the above, in the layered body 10, a diode in which a p-type semiconductor is arranged on the first electrode 181 side with the active layer 13 interposed between them and an n-type semiconductor is arranged on the second electrode 182 side is formed, and carrier holes are supplied from the first electrode 181 side and electrons are supplied from the second electrode 182 side to the active layer 13. As a specific example, n-type GaAs can be used for the substrate 11, n-type aluminum gallium arsenide (AlGaAs) can be used for the first cladding layer 121, p-type AlGaAs can be used for both the carrier block layer 14 and the second cladding layer 122, and p-type GaAs can be used for the contact layer 16.

Contrary to the above example, the substrate 11 and the first cladding layer 121 may be made of a p-type semiconductor, and the carrier block layer 14, the base body 151, the second cladding layer 122, and the contact layer 16 may be made of an n-type semiconductor. However, since an n-type semiconductor is cheaper than a p-type semiconductor, it is preferable to use an n-type semiconductor for the substrate 11 that needs to be thicker than other layers as in the above-described example in order to suppress cost of the material.

Further, positions of the active layer 13 and the two-dimensional photonic-crystal layer 15 may be opposite to those illustrated in Fig. 1. However, since each layer is sequentially stacked on the substrate 11 at the time of manufacture of the two-dimensional photonic-crystal laser 1, it is preferable to provide the active layer 13 further on the substrate 11 side (the side to be stacked first) than the two-dimensional photonic-crystal layer 15 having a hole (modified refractive index area) as illustrated in Fig. 1 because the active layer 13 can be precisely stacked without being affected by irregularities due to the presence of the hole.

Thickness of each layer constituting the layered body 10 is preferably set such that thickness $L_2$ of a combination of each layer (the substrate 11 and the first cladding layer 121) further on the second electrode 182 side than the active layer 13 is sufficiently larger than thickness Li of a combination of each layer (the carrier block layer 14, the two-dimensional photonic-crystal layer 15, the second cladding layer 122, and the contact layer 16) further on the first electrode 181 side than the active layer 13. A reason for the above will be described later together with description of operation of the two-dimensional photonic-crystal laser 1.

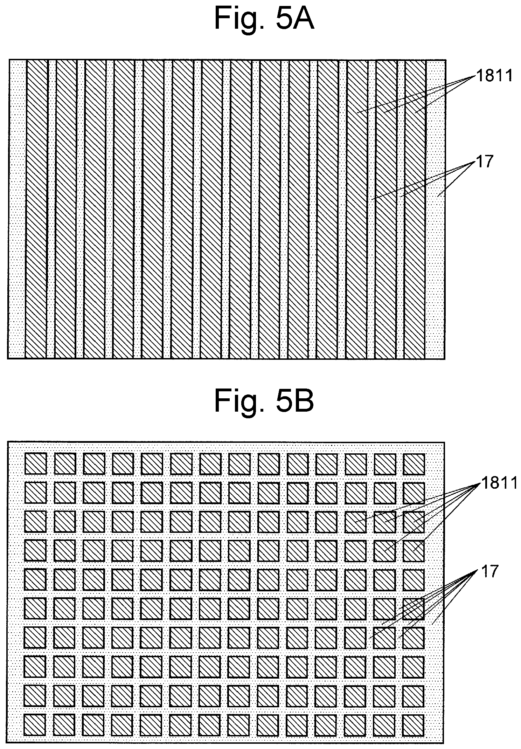

As illustrated in Figs. 5A and 5B, the first electrode 181 is divided into a large number of partial electrodes 1811 made of a conductor. The partial electrodes 1811 are arranged in a line in the example of Fig. 5A, and are arranged to be distributed two-dimensionally in the example of Fig. 5B. A planar shape of the partial electrode 1811 is rectangular in the example of Fig. 5A and square in the example of Fig. 5B, but is not limited to these shapes. Each of the partial electrodes 1811 is connected to one electrode (a positive electrode when the contact layer 16 is made of a p-type semiconductor) of a DC power supply 92 via a switch 91 provided for each of the partial electrodes 1811. For example, a field effect transistor can be used as the switch 91. Note, a wiring including the switch 91 and the DC power supply 92 are not constituents of the two-dimensional photonic-crystal laser 1.

An interval between the partial electrodes 1811 will be described later together with description of operation of the two-dimensional photonic-crystal laser 1.

Actually, a larger number of the partial electrodes 1811 are provided than those illustrated in Figs. 5A and 5B. For example, several hundred of the partial electrodes 1811 can be provided side by side in the example illustrated in Fig. 5A, and several hundred of the partial electrodes 1811 can be provided side by side in each of a longitudinal direction and a lateral direction in the example illustrated in Fig. 5B.

Between the partial electrodes 1811 and an end portion of an upper surface of the contact layer 16, where the partial electrode 1811 is not provided on the upper surface, a reflection layer (reflection portion) 17 made of an electrically insulating material and reflecting a laser beam is provided. The partial electrode 1811 also has a function of reflecting a laser beam. An object of the reflection layer 17 is to enhance light emission efficiency by reflecting a laser beam emitted from the two-dimensional photonic-crystal layer 15 toward the first electrode 181 side and emitting the laser beam from a window portion 1822 of the second electrode 182.

As illustrated in Fig. 2, the second electrode 182 includes a frame-shaped portion 1821 made of a conductor and the window portion 1822 which is a space inside the frame-shaped portion 1821. The window portion 1822 is arranged to face a region of the first electrode 181 enclosing a plurality of the partial electrodes 1811. The second electrode 182 is connected to the other electrode (negative electrode when the substrate 11 is made of an n-type semiconductor) of the DC power supply 92.

In the present embodiment, a plano-convex lens in which one surface is a convex surface and the other surface is a flat surface is used as the lens 19. Instead of a plano-convex lens, a lens in which both surfaces are convex surfaces may be used. Alternatively, a concave lens may be used as the lens 19. The lens 19 is preferably arranged apart from the two-dimensional photonic-crystal layer 15 by the distance $L_{LP}$ that is 0.5 to 2 times a focal length f of the lens 19, and more preferably arranged apart from the two-dimensional photonic-crystal layer 15 by the distance equal to the focal length f of the lens 19. By the above, it is possible to suppress expansion of a diameter of a laser beam that passes through the lens 19.

Further, instead of the lens 19 exemplified above, a lens or a prism (in the present application, a prism is also included in the lens) in which one or both of a surface curvature and a focal length are variable by electrical control or the like, such as an electrowetting lens or a liquid crystal lens, may be used. In this case, a control unit that performs electrical control or the like for changing a surface curvature and/or a focal length of the lens is used.

(a-2) Operation of two-dimensional photonic-crystal laser of first embodiment

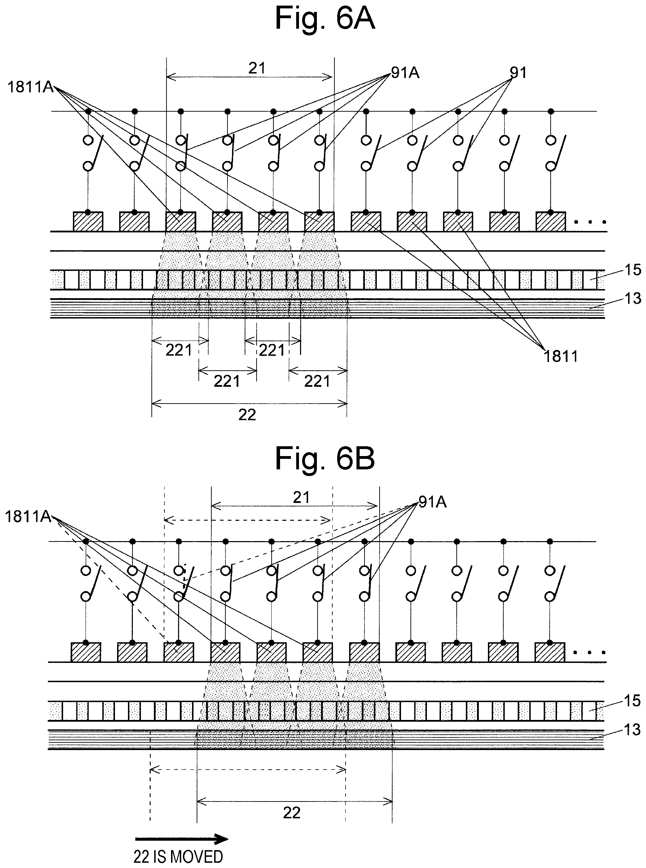

Operation of the two-dimensional photonic-crystal laser 1 of the first embodiment will be described with reference to Figs. 6 to 10.

When the two-dimensional photonic-crystal laser 1 is used, one or a plurality of switches 91A connected to one or a plurality of adjacent ones of the partial electrodes 1811 (these one or a plurality of adjacent ones of the partial electrodes 1811 are referred to as "partial electrode group 1811A", and a region where the partial electrode group 1811A exists is referred to as "electric current supplying region 21", see Fig. 6A) among the switches 91 provided for each of the partial electrodes 1811 are switched on. In the example illustrated in Fig. 6A, the switches 91 of four of the partial electrodes 1811 included in the partial electrode group 1811A are switched on, but the number is not limited to this.

By the above, electric current flows between one or a plurality of the partial electrodes 1811 constituting the one partial electrode group 1811A and the second electrode 182, and carrier holes are supplied from each of the partial electrodes 1811, and electrons are supplied from the second electrode 182 into the layered body 10. When electric current flows from the partial electrode group 1811A, the electric current flows so as to slightly spread in a direction parallel to the active layer 13 from each of the partial electrodes 1811 toward the second electrode 182. For this reason, in a case where an interval between adjacent ones of the partial electrodes 1811 is smaller than a certain threshold, a partial electric current flow region 221, which is a region where the electric current is supplied from each of the partial electrodes 1811 to the active layer 13, overlaps a part of the partial electric current flow region 221 of the electric current supplied from an adjacent one of the partial electrode 1811. As a result, an electric current flow region 22 that is integrated is formed in the active layer 13 (Fig. 6A).

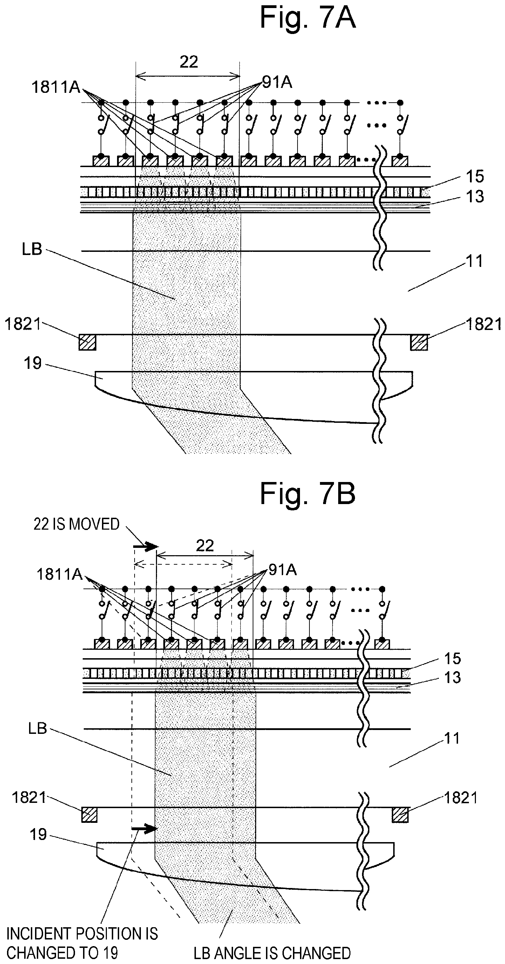

On the active layer 13, light having a predetermined wavelength range determined by the material of the active layer 13 is generated in the electric current flow region 22. Of this light, light having a wavelength corresponding to a period of the modified refractive index area 152 in the two-dimensional photonic-crystal layer 15 is amplified in a region (light amplification region) corresponding to the electric current flow region 22 in the two-dimensional photonic-crystal layer 15 and laser oscillation occurs. Then, a laser beam LB is emitted in a direction perpendicular to the two-dimensional photonic-crystal layer 15, passes through the window portion 1822 of the second electrode 182, and enters the lens 19 (Fig. 7A). The laser beam LB is refracted in a direction corresponding to an entry position into the lens 19, and is emitted to the outside of the two-dimensional photonic-crystal laser 1 in a direction inclined from a direction perpendicular to the two-dimensional photonic-crystal layer 15.

The direction of the laser beam LB emitted to the outside of the two-dimensional photonic-crystal laser 1 is changed as described below as the partial electrode 1811 to which electric current is supplied is changed. For example, as illustrated in Fig. 6B, among the four of the partial electrodes 1811 constituting the partial electrode group 1811A illustrated in Fig. 6A, the switch 91 of the partial electrode 1811 at the left end in Fig. 6A is switched off, and the switch 91 of the partial electrode 1811 adjacent on the right, which is switched off in Fig. 6A, is newly switched on. By the above, the electric current supplying region 21 is moved to the right as far as one of the partial electrode 1811, and accordingly, the electric current flow region 22 and the light amplification region in the active layer 13 are also moved to the right. Then, the entry position into the lens 19 of the laser beam LB emitted from the two-dimensional photonic-crystal layer 15 is also moved to the right side (Fig. 7B). As a result, the laser beam LB is refracted in a direction different from that in the case of Fig. 7A according to a difference in the entry position, and is emitted to the outside of the two-dimensional photonic-crystal laser 1 in a different inclination direction.

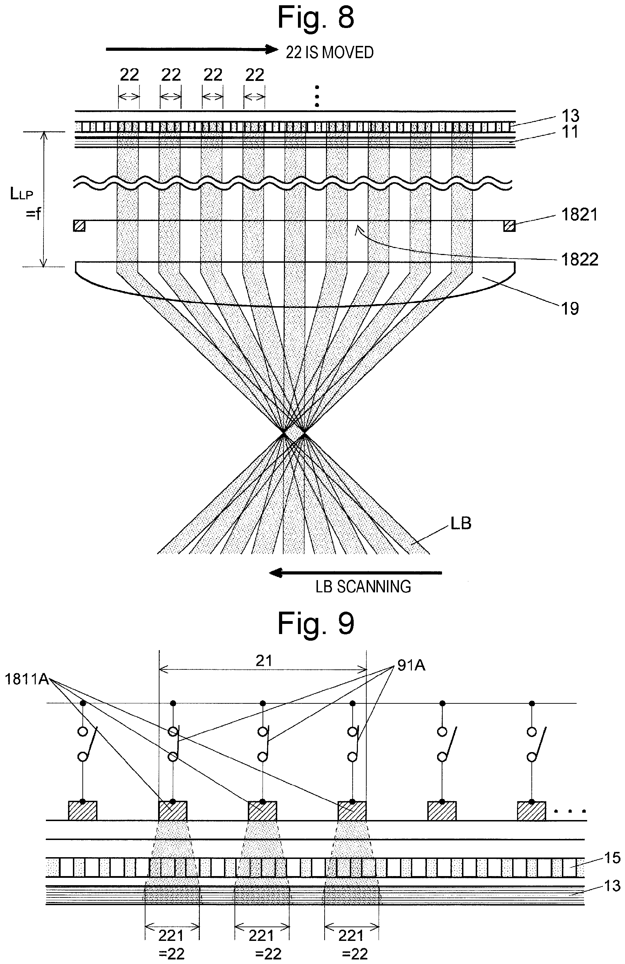

As described above, by changing the partial electrode 1811 included in the partial electrode group 1811A to move the electric current flow region 22, an inclination direction of the laser beam LB emitted from the lens 19 to the outside of the two-dimensional photonic-crystal laser 1 is changed, so that scanning with the laser beam LB can be performed as illustrated in Fig. 8. At this time, since the laser beam LB passes through the window portion 1822 of the second electrode 182 before entering the lens 19, the laser beam LB can be emitted without being attenuated by the second electrode 182.

Although Fig. 8 illustrates a state in which the laser beam LB is moved one-dimensionally, if the partial electrodes 1811 are arranged two-dimensionally as illustrated in Fig. 5B, the laser beam LB can be moved two-dimensionally.

In the case of using a lens whose surface curvature and/or focal length is variable by electrical control or the like as described above, it is possible to perform scanning with the laser beam LB by electrically switching the partial electrodes 1811 included in the partial electrode group 1811A and also by changing the surface curvature and/or focal length of the lens. In general, a response speed when the partial electrodes 1811 included in the partial electrode group 1811A are electrically switched is faster than a response speed when a surface curvature or a focal length of the lens is changed. In consideration of this point, for example, it is possible to perform scanning with the laser beam LB two-dimensionally by scanning with the laser beam LB in one direction by changing a surface curvature and/or a focal length of the lens during repeated scanning with the laser beam LB in a direction different from the one direction (for example, a direction perpendicular to the one direction) by operation of electrically switching the partial electrodes 1811 included in the partial electrode group 1811A with respect to the partial electrodes 1811 arranged one-dimensionally.

In Figs. 6A and 6B, the case where an interval between adjacent ones of the partial electrodes 1811 is smaller than a certain threshold is described. However, in a case where the interval between adjacent ones of the partial electrodes 1811 is larger than a certain threshold, the partial electric current flow regions 221 of electric current supplied from each of the partial electrodes 1811 do not overlap each other, and a plurality of the electric current flow regions 22 that are divided are formed in the active layer 13 (Fig. 9). When the electric current flow region 22 divided in this manner is formed, low-coherence (incoherent) laser oscillation occurs in the two-dimensional photonic-crystal layer 15. On the other hand, as illustrated in Figs. 6A and 6B, by setting the interval between adjacent ones of the partial electrodes 1811 so as to form the electric current flow region 22 that is integrated, a highly coherent (coherent) laser beam can be obtained.

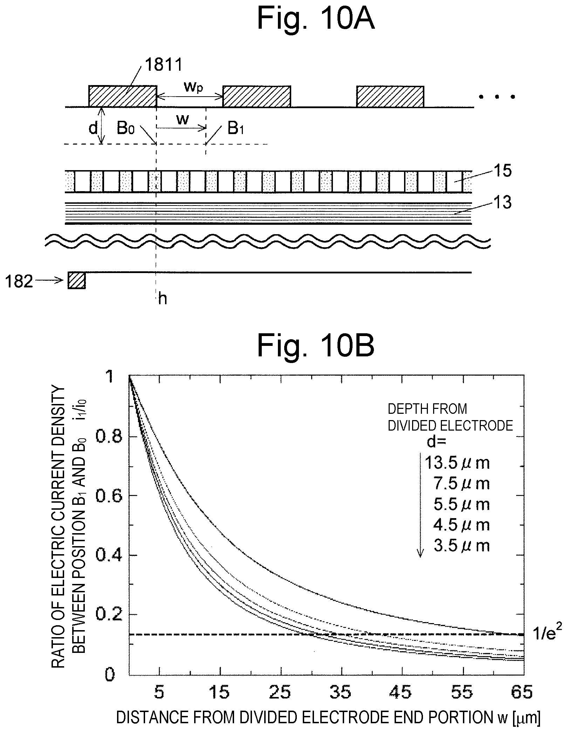

The interval between the partial electrodes 1811 can be appropriately determined by performing a preliminary experiment or simulation. As an example, simulation was performed as described below under a condition illustrated in Fig. 10A. In this simulation, in a case where an interval (gap) between the partial electrodes 1811 is $w_p$, at a position of the depth (distance in a direction perpendicular to the active layer 13) d sufficiently smaller than the distance from one of the partial electrodes 1811 to the second electrode 182, a ratio $i_1/i_0$ which is a ratio of an electric current density ii to an electric current density $i_0$, where the electric current density $i_0$ is at a position $B_0$ intersecting a perpendicular h from an end portion of the partial electrode 1811 and the electric current density ii is at a position $B_1$ separated by the distance w from the position $B_0$ in a manner parallel to the active layer 13 and to the opposite side of the partial electrode 1811 was obtained. Specifically, the distance between the partial electrode 1811 and the second electrode 182 was (154 + d) $\mu$m, d was within a range of 3.5 to 12.5 $\mu$m, and w was within a range of 0 to 65 $\mu$m. Although a width of the partial electrode 1811 was set to 30 $\mu$m, the influence of this value on a calculation result is small.

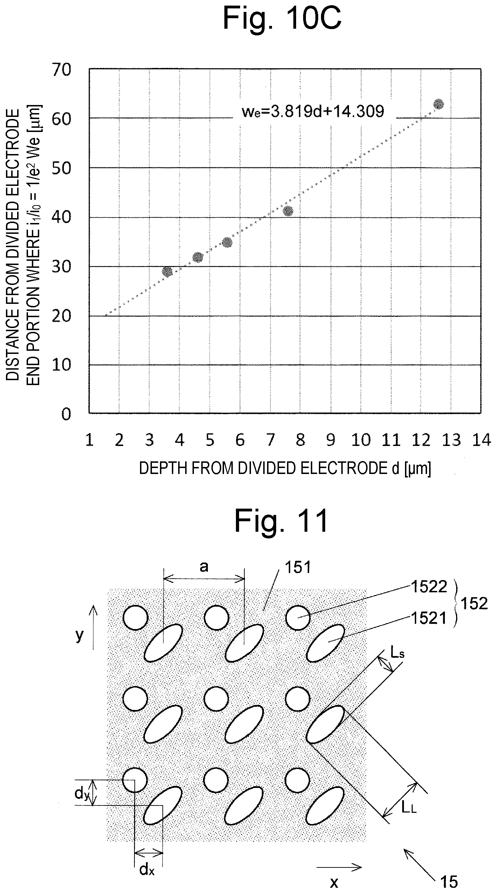

Fig. 10B illustrates a calculation result. In any case where the distance d is any value, the ratio $i_1/i_0$ of the electric current density decreases as w increases, that is, as the distance from an end portion of the partial electrode 1811 becomes larger. A range in which $i_1/i_0$ is larger than a certain value (defined as $1/e^2$ in this example) is defined as a range in which electric current spreads. In view of the above, for each of the distances d, a value $w_e$ of the distance w when $i_1/i_0 = 1/e^2$ was obtained. Fig. 10C illustrates a result. When the obtained data is approximated by a linear function, $w_e = 3.819d + 14.309$.

Using this calculation result, when the active layer 13 is present at a position of the depth d from the partial electrode 1811, the interval $w_p$ between the partial electrodes 1811 is set to $2w_e$ or less. By the above, at a depth position of the active layer 13, the partial electric current flow region 221 formed by each of two of the partial electrodes 1811 extends by the distance $w_e$ or more in a direction parallel to the active layer 13, and thus the partial electric current flow regions 221 overlap each other. For this reason, the electric current flow region 22 that is integrated can be formed, and a coherent laser beam can be obtained.

Size of each of the partial electrodes 1811 is preferably small because the smaller the size, the more finely the position of the electric current flow region 22 can be set, which allows precise control of an inclination direction of a laser beam. For example, in the case where the partial electrodes 1811 are arranged one-dimensionally as illustrated in Fig. 5A, by setting the size of each of the partial electrodes 1811 so that 10 to 50 of the partial electrodes 1811 are included in the electric current flow region 22, the position of the electric current flow region 22 is moved by 2% to 10% of the area of the electric current flow region 22 by one time of ON/OFF operation of the switch 91. Similarly, in the case where the partial electrodes 1811 are arranged two-dimensionally as illustrated in Fig. 5B, the size of each of the partial electrodes 1811 can be set so that 10 to 50 of the partial electrodes 1811 are arranged per side of the rectangular electric current flow region 22.

The size of the electric current flow region 22 and the number of the switches 91 that influence the size and are simultaneously switched on are determined so as to obtain necessary optical output according to the application of the two-dimensional photonic-crystal laser 1. For example, in a case of use for sensing applications such as laser imaging detection and ranging (LiDAR), optical output of 1 W to several tens of W is required by pulsed light, and accordingly, the size of the electric current flow region 22 is preferably set within a range of a rectangle (including a square) where each side is 10 $\mu$m to 500 $\mu$m. Further, in a case of use for laser processing or the like, optical output of the order of 100 W to 1000 W is required, and accordingly, the size of the electric current flow region 22 is preferably set within a range of a rectangle where each side is 1 mm to 1 cm.

(a-3) Design of two-dimensional photonic-crystal layer for adjusting optical output

In the two-dimensional photonic-crystal laser 1, the size of the electric current flow region 22 and the like are designed so that optical output according to the application can be obtained. One target of such design is a configuration of a two-dimensional photonic-crystal layer. Hereinafter, an example of the design will be described.

Conventionally, in a two-dimensional photonic-crystal laser, it is known that intensity of light in a two-dimensional photonic-crystal layer is increased by increase in interference of light generated when light propagating in the two-dimensional photonic-crystal layer is diffracted by a modified refractive index area, but when the interference is too strong, the light is easily confined in the two-dimensional photonic-crystal, so that output of light emitted to the outside of the two-dimensional photonic-crystal may be rather reduced. Therefore, in the two-dimensional photonic-crystal laser described in Patent Literature 4, a two-dimensional photonic-crystal layer in which two holes of a main modified refractive index area (corresponding to the first partial modified refractive index area 1521 of the present embodiment) and a sub-modified refractive index area (corresponding to the second partial modified refractive index area 1522 of the present embodiment) or one modified refractive index area including a member having a refractive index different from that of a base body are two-dimensionally and periodically arranged is used. In this two-dimensional photonic-crystal laser, positions of the main modified refractive index area and the sub-modified refractive index area are set such that interference light between diffracted light diffracted in the 180° direction by the main modified refractive index area and diffracted light diffracted in the 180° direction by the sub-modified refractive index area among light propagating in the two-dimensional photonic-crystal layer is intensified or weakened according to a purpose.

In the present specification, a two-dimensional photonic-crystal layer is designed in consideration of interference between diffracted light (180° diffracted light) diffracted in the 180° direction by two partial modified refractive index areas (the first partial modified refractive index area 1521 and the second partial modified refractive index area 1522) and diffracted light (90° diffracted light) diffracted in a 90° direction. Specifically, as illustrated in Fig. 11, with one of two orthogonal directions in which lattice points of square lattice are arranged closest to each other as the x direction and the other as the y direction, parameters such as distances $d_x$ and $d_y$ with respect to the x direction and the y direction between two partial modified refractive index areas, a ratio fi/fz of filling factors $f_1$ and $f_2$ of two partial modified refractive index areas (a ratio of volumes of each partial modified refractive index area to the entire two-dimensional photonic-crystal layer 15), and a difference $(c_1 - c_2)$ between flatness $c_1$ and $c_2$ of two partial modified refractive index areas (when a length in a longest direction in a planar shape of the partial modified refractive index area is $L_L$ and a length in a direction perpendicular to the direction is $L_s$, $c = 1 - (L_s/L_L)$) are set. By appropriately changing these parameters, the diffraction efficiency $|\kappa_{180}|$ of the 180° diffracted light and the diffraction efficiency $|-\kappa_{90}|$ of the 90° diffracted light in each of the two partial modified refractive index areas are changed, and accordingly, the intensity of interference between the 180° diffracted light and the 90° diffracted light by the two partial modified refractive index areas is changed, and thus, the intensity of a laser beam emitted to the outside of the two-dimensional photonic-crystal laser is also changed. Here, $\kappa_{180}$ and $-\kappa_{90}$ are parameters that are called coupling coefficients and represent intensity of diffracted light, and may take either positive or negative values. As $|\kappa_{180} + \kappa_{90}|$, which is the absolute value of the difference between $\kappa_{180}$ and $-\kappa_{90}$, becomes closer to zero, the intensity of the interference light of the 180° diffracted light and the 90° diffracted light becomes weaker. By the above, an effect that light is confined in the two-dimensional photonic-crystal layer is suppressed.

In order to increase the intensity of the laser beam emitted to the outside of the two-dimensional photonic-crystal laser, a difference of coupling coefficients, $|\kappa_{180} - (-\kappa_{90})| = |\kappa_{180} + \kappa_{90}|$ is preferably close to zero. In view of the above, regarding the two-dimensional photonic-crystal layer 15 illustrated in Fig. 11, calculation for obtaining $|\kappa_{180} + \kappa_{90}|$ was performed for a plurality of cases where (a) the distance $d_x$ ($d_x = d_y$) in the x direction between the first partial modified refractive index area 1521 and the second partial modified refractive index area 1522, (b) the filling factor ratio $f_1/f_2$, and (c) the difference $c_1 - c_2$ in flatness are different. In any calculation, the first partial modified refractive index area 1521 was set to a perfect circle ($c_1 = 0$) or an ellipse ($c_1 \neq 0$) having a major axis in a direction inclined by 45° with respect to the x direction, and the second partial modified refractive index area 1522 was set to a perfect circle ($c_2 = 0$). A value of $d_x$ was set to 0.262a in (b) and (c), $f_1/f_2$ was set to 1.33 in (a) and (c), and $c_1$ was changed in each calculation. As illustrated in Fig. 11, in a case where the shape of the modified refractive index area does not have rotational symmetry, there is a case where, among the two-dimensional coupling coefficients, one representing reflection (90° diffraction) with respect to a straight line $y = -x$ and one representing reflection (90° diffraction) with respect to a straight line $y = x$ take different values. In such a case, a difference $|\kappa_{180} - (-\kappa_{90})| = |\kappa_{180} + \kappa_{90}|$ from at least one of the two-dimensional coupling coefficients and $\kappa_{180}$ is preferably close to zero, and a difference between both the two-dimensional coupling coefficients and $\kappa_{180}$ is more preferably close to zero. In the calculation, the reflection (90° diffraction) with respect to the straight line $y = x$ was defined as $\kappa_{90}$.

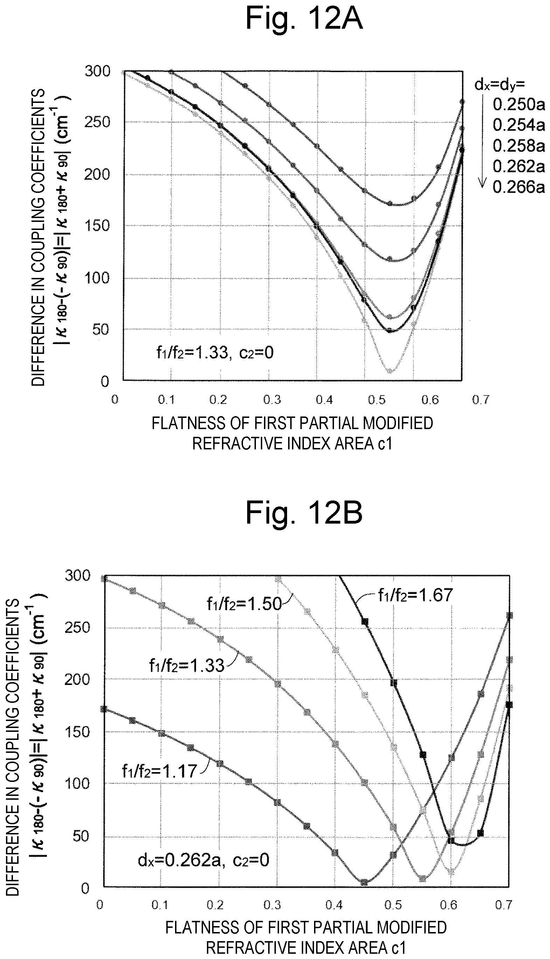

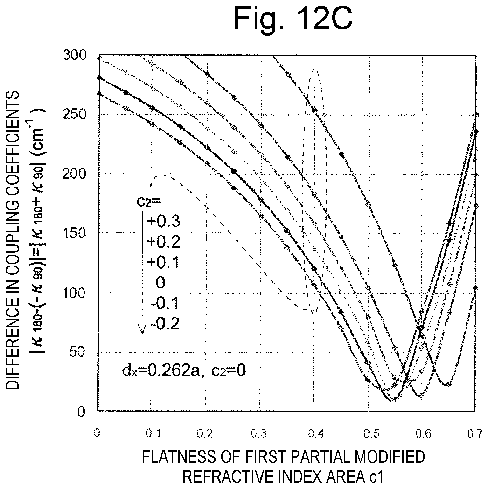

Calculation results are illustrated in Fig. 12A for (a), Fig. 12B for (b), and Fig. 12C for (c). In (a), when $d_x$ ($= d_y$) is in a range of 0.258a to 0.266a and $c_1$ is in the range of 0.50 to 0.60, $|\kappa_{180} + \kappa_{90}|$ is suppressed to a value of 100 cm$^{-1}$ or less. In (b), by setting $c_1$ within a certain range (for example, when $f_1/f_2 = 1.5$, $c_1$ is set within a range of 0.55 to 0.65) in the entire range (1.17 to 1.67) of $f_1/f_2$ calculated, $|\kappa_{180} + \kappa_{90}|$ is suppressed to a value of 100 cm$^{-1}$ or less. In also (c), by setting $c_1$ within a certain range (for example, when $c_2 = 0$, $c_1$ is set within a range of 0.50 to 0.60), $|\kappa_{180} + \kappa_{90}|$ is suppressed to a value of 100 cm$^{-1}$ or less. By performing the calculation as in the above example, the distance, the filling factor, and the flatness of the first partial modified refractive index area 1521 and the second partial modified refractive index area 1522 can be designed.

(a-4) Variation of two-dimensional photonic-crystal laser of first embodiment

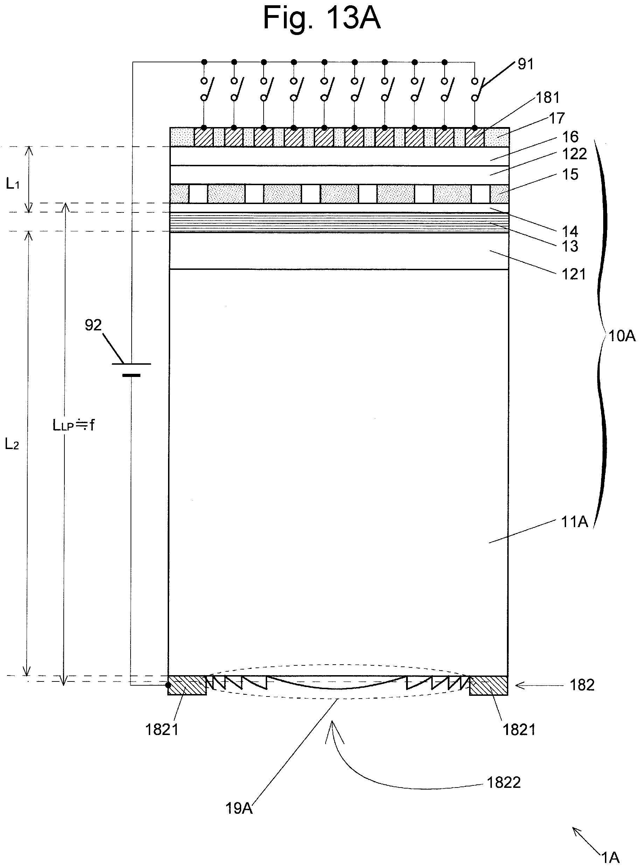

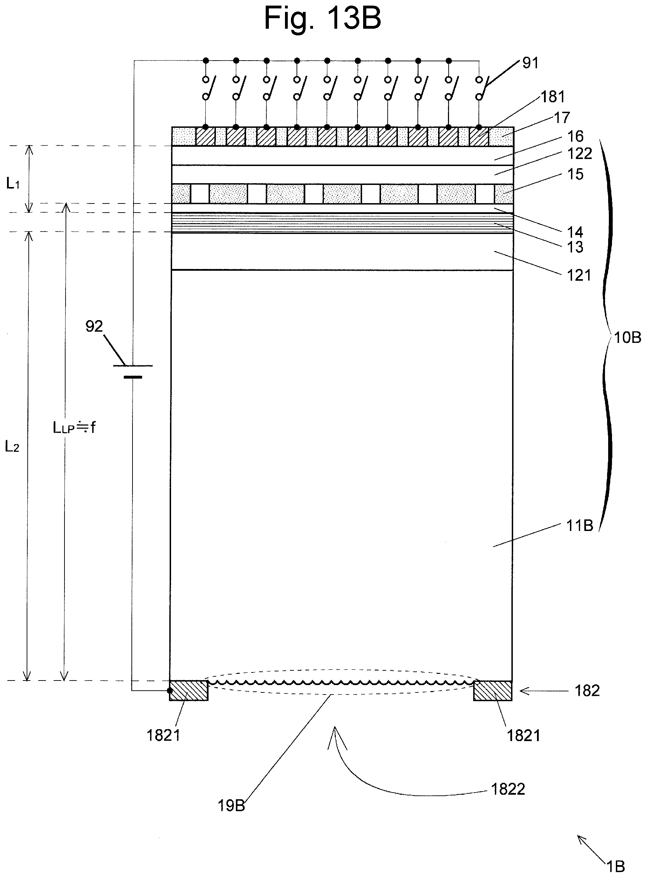

A variation of the two-dimensional photonic-crystal laser of the first embodiment will be described with reference to Figs. 13A and 13B.

In a two-dimensional photonic-crystal laser 1A illustrated in Fig. 13A, a layered body 10A is provided instead of the layered body 10 in the two-dimensional photonic-crystal laser 1. In the layered body 10A, a lens 19A is formed at a position facing the window portion 1822 on the surface on the second electrode 182 side. No lens is provided on the opposite side of the second electrode 182. The lens 19A is obtained by processing a surface of a substrate 11A into a shape of a Fresnel lens. A Fresnel lens is obtained in a manner that a normal lens is divided into concentric regions, and thickness of a region between concentric circles is reduced to a predetermined value or less while maintaining a shape of a curved surface on one surface (a surface of the substrate 11A in the present variation), so that the surface has a sawtooth shape. A configuration of the two-dimensional photonic-crystal laser 1A other than the points described above is similar to the configuration of the two-dimensional photonic-crystal laser 1.

In a two-dimensional photonic-crystal laser 1B illustrated in Fig. 13B, a layered body 10B is provided instead of the layered body 10 in the two-dimensional photonic-crystal laser 1. A lens 19B is formed at a position facing the window portion 1822 on a surface of the layered body 10B on the second electrode 182 side. No lens is provided on the opposite side of the second electrode 182. The lens 19B is called a metalens in which a surface of a substrate 11B is processed with accuracy equal to or less than the length of a wavelength of a laser beam, and a fine structure (metasurface) capable of controlling the phase of transmitted light is appropriately formed in the surface to have a lens function. The metalens can be considered substantially flat and can be sufficiently small in thickness. Other configurations of the two-dimensional photonic-crystal laser 1B are similar to those of the two-dimensional photonic-crystal laser 1.

According to the two-dimensional photonic-crystal lasers 1A and 1B of the present variation, the size of the two-dimensional photonic-crystal laser can be reduced as compared with the case where the lens 19 separate from the layered body 10 is provided.

In the two-dimensional photonic-crystal laser 1, the reflection layer (reflection portion) 17 that reflects a laser beam is provided between the partial electrodes 1811 and in an end portion of an upper surface of the contact layer 16, but instead, a distributed Bragg reflector made of a conductive semiconductor material may be provided between the two-dimensional photonic-crystal layer 15 and the partial electrode 1811. A positional relationship between the distributed Bragg reflector and the second cladding layer 122 and the contact layer 16 is not particularly limited. By the above, a laser beam emitted from the two-dimensional photonic-crystal layer 15 to the first electrode 181 side is reflected by the distributed Bragg reflector and emitted from the window portion 1822 of the second electrode 182, and light emission efficiency can be increased. The distributed Bragg reflector can be configured by, for example, a periodic structure in which a layer made of doped GaAs and a layer made of doped AlAs are alternately laid.

In addition to the points described above, a person skilled in the art can further modify the two-dimensional photonic-crystal laser of the first embodiment and the variations of the first embodiment within the scope of the present invention.

(b) Two-dimensional photonic-crystal laser of second embodiment

(b-1) Configuration of two-dimensional photonic-crystal laser of second embodiment

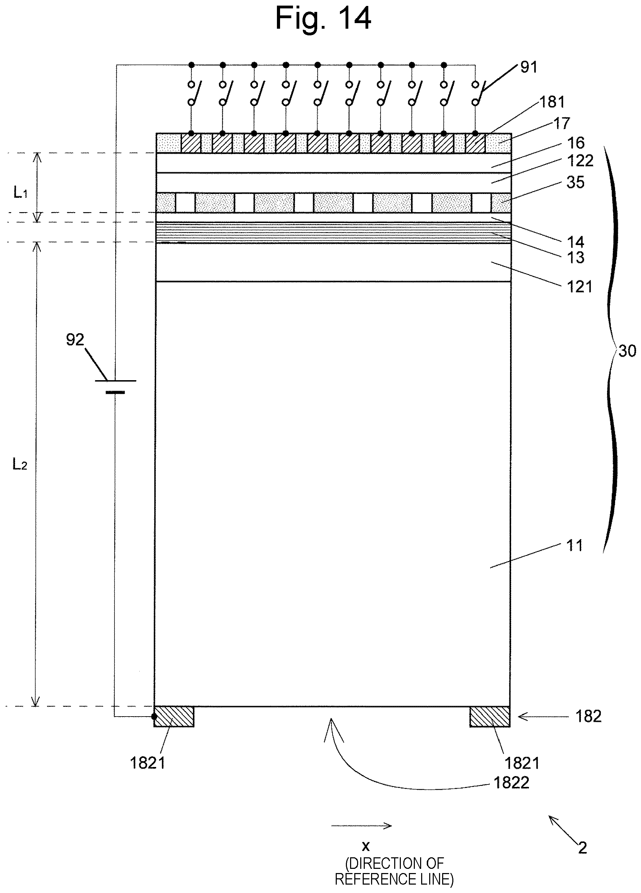

As illustrated in Fig. 14, a two-dimensional photonic-crystal laser 2 of a second embodiment is different from the configuration of the two-dimensional photonic-crystal laser 1 of the first embodiment in including a layered body 30 including a two-dimensional photonic-crystal layer 35 having a configuration different from that of the two-dimensional photonic-crystal layer 15 in the two-dimensional photonic-crystal laser 1 of the first embodiment and not including the lens 19. Except for these two points, the two-dimensional photonic-crystal laser 2 of the second embodiment has a configuration common to that of the two-dimensional photonic-crystal laser 1 of the first embodiment. For this reason, description of the common configuration is omitted, and the configuration of the two-dimensional photonic-crystal layer 35 will be described below.

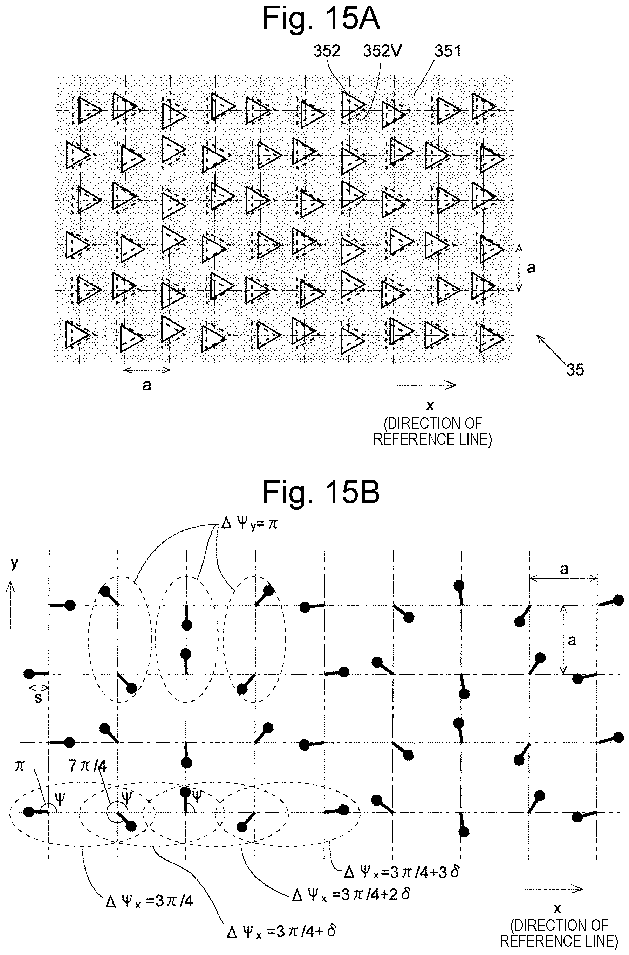

As illustrated in Fig. 15A, in the two-dimensional photonic-crystal layer 35, a modified refractive index area 352 is arranged in a plate-shaped base body 351 as described below. In the example illustrated in Fig. 15A, a planar shape of the modified refractive index area 352 includes one equilateral triangle, but a shape of the modified refractive index area 352 of the second embodiment is not limited to this example. In Fig. 15A, the modified refractive index area 352 actually provided in the two-dimensional photonic-crystal layer 35 is indicated by a solid line, a square lattice which is a basic two-dimensional lattice is indicated by a one-dot chain line, and a state in which the center of gravity of a modified refractive index area 352V is virtually arranged at the lattice point of the square lattice is indicated by a broken line. Further, Fig. 15B illustrates a position of the center of gravity (black circle) of a square lattice (one-dot chain line) and the actual modified refractive index area 352.

In the two-dimensional photonic-crystal layer 35, the distance between the lattice point and the actual center of gravity of the modified refractive index area 352 (the magnitude s of the positional deviation) is the same at all lattice points, and the deviation direction is modulated as described below. When the lattice constant of the square lattice is a, a position vector $r\uparrow$ of each lattice point is expressed as $r\uparrow = (m_x a, m_y a)$ using integers $m_x$ and $m_y$ in an orthogonal coordinate system. Further, the x direction is defined as a direction of a reference line, a design value of an inclination angle of a laser beam is defined as θ, and an azimuth angle φ from the reference line is defined. In this case, a wavevector $k\uparrow$ is $k\uparrow = (\pi/a, \pi/a)$, and a reciprocal lattice vector $G' = (g'_x, g'_y)$ is given by:
[Equation 2]

$$g'_x = \left( \frac{1}{2} \pm \frac{1}{\sqrt{2}n_{\text{eff}}} \sin\theta \cos\phi \right) \cdot \frac{2\pi}{a}$$
$$g'_y = \left( \frac{1}{2} \pm \frac{1}{\sqrt{2}n_{\text{eff}}} \sin\theta \sin\phi \right) \cdot \frac{2\pi}{a}$$

$$\ldots (2)$$

Therefore, a modulation phase $\Psi = r\uparrow \cdot G'\uparrow$ of each lattice point in this case is expressed as follows:
[Equation 3]

$$\Psi = 2\pi \left[ \left( \frac{1}{2} \pm \frac{1}{\sqrt{2}n_{\text{eff}}} \sin\theta \cos\phi \right) m_x + \left( \frac{1}{2} \pm \frac{1}{\sqrt{2}n_{\text{eff}}} \sin\theta \sin\phi \right) m_y \right]$$

$$\ldots (3).$$

For example, in a case where a design value of the inclination angle θ is 36.2° and the azimuth angle φ is 0°, the angle (hereinafter, "shifted azimuth angle") $\Psi$ formed by the modulation phase, that is, the direction of the shift and the reference line is (3/4) $\pi m_x + \pi m_y$, and a difference $\delta\Psi$ of the shifted azimuth angle between the modified refractive index areas 352 adjacent in the x direction is (3/4)π (for the description of this paragraph so far, see Patent Literature 2 or 3). When the shifted azimuth angle $\Psi$ is changed to a different value, laser beams having different inclination angles θ (that is, emission directions) are obtained.

In view of the above, in the two-dimensional photonic-crystal laser 2 of the second embodiment, the shifted azimuth angle $\Psi$ is set such that the value of the inclination angle θ in Equation (3) is different for each position (position vector $r\uparrow = (m_x a, m_y a)$) in the two-dimensional photonic-crystal layer 35. For example, as illustrated in Fig. 15B, the shifted azimuth angle $\Psi$ at each position is set such that a difference $\Delta\Psi_x$ of the shifted azimuth angles $\Psi$ between the modified refractive index areas 352 adjacent in the x direction increases by δ in the x direction. A plurality of the partial electrodes 1811 are provided so as to be arranged in the x direction.

(b-2) Operation of two-dimensional photonic-crystal laser of second embodiment

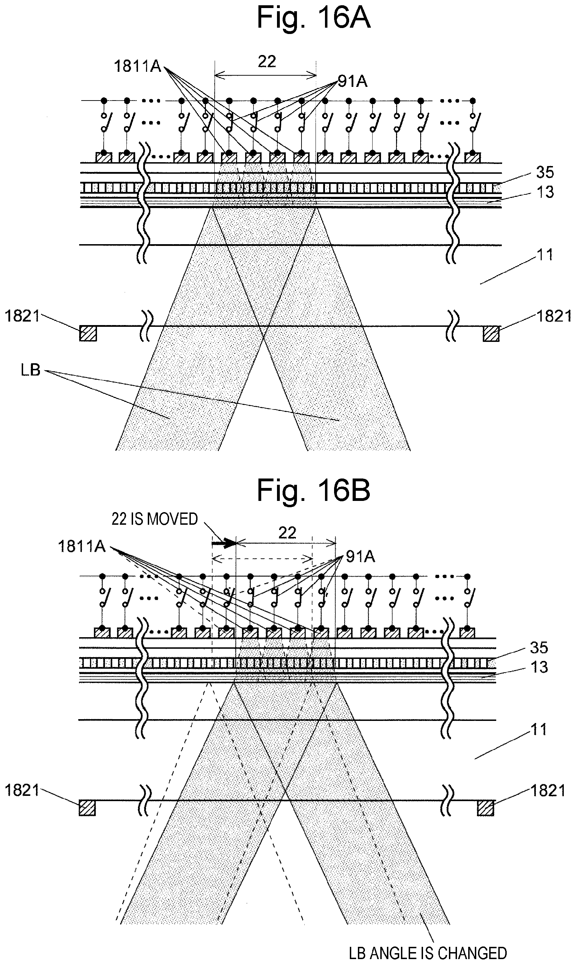

When the two-dimensional photonic-crystal laser 2 of the second embodiment is used, similarly to the case of the first embodiment, among the switches 91 provided for each of the partial electrodes 1811, the switches 91A of one or a plurality of the partial electrodes 1811 constituting the partial electrode group 1811A are switched on, so that electric current flows between the one or plurality of the partial electrodes 1811 and the second electrode 182, and electric current is supplied to the electric current flow region 22 that is a part of the active layer 13. By the above, in the active layer 13, light having a predetermined wavelength range is generated in the electric current flow region 22, and of the light, light having a wavelength corresponding to a period of the modified refractive index area 152 in the two-dimensional photonic-crystal layer 15 is amplified in a region (light amplification region) corresponding to the electric current flow region 22 in the two-dimensional photonic-crystal layer 35 and laser oscillation occurs. The laser beam LB is emitted to the outside of the two-dimensional photonic-crystal laser 2 in a direction inclined by an inclination angle according to the angle θ that defines the shifted azimuth angle Ψ in the light amplification region of the two-dimensional photonic-crystal layer 35 (Fig. 16A). In the two-dimensional photonic-crystal layer 35 of the example illustrated in Figs. 15A and 15B, since the angle θ defining the shifted azimuth angle Ψ differs depending on a position in one light amplification region, an inclination angle of the laser beam LB is approximately an average value of the angles θ in the light amplification region.

When the partial electrode 1811 to which electric current is supplied is changed, the position of the electric current flow region 22 is moved, and accordingly, the region where light is amplified in the two-dimensional photonic-crystal layer 35 is also moved. By the above, since a range of values of the shifted azimuth angle Ψ and the angle θ that determines the shifted azimuth angle Ψ in the light amplification region is changed, an inclination angle of the laser beam LB is also changed (Fig. 16B). By the above, since an inclination angle of the laser beam LB emitted to the outside of the two-dimensional photonic-crystal laser 2 is changed, scanning with the laser beam LB can be performed. Further, when the laser beam LB is emitted to the outside of the two-dimensional photonic-crystal laser 2, the laser beam LB passes through the window portion 1822 of the second electrode 182. For this reason, the laser beam LB can be emitted without being attenuated by the second electrode 182.

(b-3) Variation of two-dimensional photonic-crystal laser of second embodiment

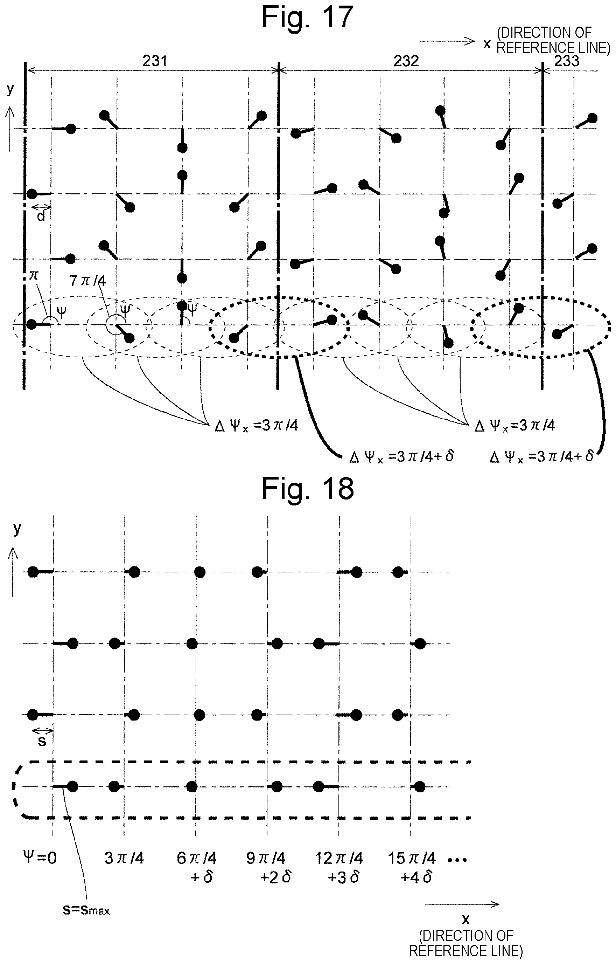

A variation of the second embodiment will be described. For example, in the examples illustrated in Figs. 15A and 15B, the angles θ defining the shifted azimuth angle Ψ are set to different values between all lattice points adjacent in the x direction. However, as illustrated in Fig. 17, the two-dimensional photonic-crystal layer 35 may be divided into shifted azimuth angle setting regions 231, 232, 233 ... having a plurality of lattice points in the x direction, the angles θ may be set to the same value in the same ones of the shifted azimuth angle setting regions 231, 232, and 233, and the angles θ may be set to different values between different ones of the shifted azimuth angle setting regions 231, 232, and 233.

In the examples illustrated in Figs. 15A and 15B, a square lattice is used as the basic two-dimensional lattice, but another two-dimensional lattice such as a rectangular lattice shape or a triangular lattice shape may be used as the basic two-dimensional lattice. For example, in a case where a rectangular lattice of lattice constants $a_1$ and $a_2$ is set to the basic two-dimensional lattice, the reciprocal lattice vector G' = ($g'_x$, $g'_y$) is

[Equation 4]

$$g'_x = \left( \frac{1}{a_1} \pm \sqrt{\frac{1}{a_1^2} + \frac{1}{a_2^2}} \frac{\sin\theta\cos\phi}{n_{\text{eff}}} \right) \cdot \pi$$

$$g'_y = \left( \frac{1}{a_2} \pm \sqrt{\frac{1}{a_1^2} + \frac{1}{a_2^2}} \frac{\sin\theta\sin\phi}{n_{\text{eff}}} \right) \cdot \pi$$

$$\dots (4),$$

and the modulation phase Ψ of each lattice point is
[Equation 5]

$$\Psi = \pi \left[ \left( 1 \pm \sqrt{1 + \frac{a_1^2}{a_2^2}} \frac{\sin\theta\cos\phi}{n_{\text{eff}}} \right) m_x + \left( 1 \pm \sqrt{1 + \frac{a_2^2}{a_1^2}} \frac{\sin\theta\sin\phi}{n_{\text{eff}}} \right) m_y \right]$$

$$\dots (5).$$

Further, in a case where the basic two-dimensional lattice is a triangular lattice having a lattice constant a, the position vector r↑ of the lattice point is expressed as r↑ = ($m_1a + (1/2)m_2a$, $(3^{1/2}/2)m_2a$) using integers $m_1$ and $m_2$ in an orthogonal coordinate system, and the reciprocal lattice vector G' = ($g'_x$, $g'_y$) is
[Equation 6]

$$g'_x = \left(1 \pm \frac{\sin\theta\cos\phi}{n_{\text{eff}}}\right)\cdot\frac{4\pi}{3a}$$

$$g'_y = \pm\frac{\sin\theta\cos\phi}{n_{\text{eff}}}\cdot\frac{4\pi}{3a}$$

$$\dots (6)$$

or [Equation 7]

$$g'_x = \left(1 \pm 2\frac{\sin\theta\cos\phi}{n_{\text{eff}}}\right)\cdot\frac{2\pi}{3a}$$

$$g'_y = \left(\sqrt{3} \pm 2\frac{\sin\theta\sin\phi}{n_{\text{eff}}}\right)\cdot\frac{2\pi}{3a}$$

$$\dots (7).$$

In a case where the reciprocal lattice vector G' is expressed by Equation (6), the modulation phase $\Psi$ = of each lattice point is
[Equation 8]

$$\Psi = \left(1 \pm \frac{\sin\theta\cos\phi}{n_{\text{eff}}}\right)\cdot\frac{4\pi}{3}\left(m_1 + \frac{1}{2}m_2\right) \pm \frac{\sin\theta\cos\phi}{n_{\text{eff}}}\cdot\frac{2\sqrt{3}\pi}{3}m_2$$

$$\dots (8)$$

and in a case where the reciprocal lattice vector G' is expressed by Equation (7),
[Equation 9]

$$\Psi = \left(1 \pm 2\frac{\sin\theta\cos\phi}{n_{\text{eff}}}\right)\cdot\frac{2\pi}{3}\left(m_1 + \frac{1}{2}m_2\right) + \left(\sqrt{3} \pm 2\frac{\sin\theta\sin\phi}{n_{\text{eff}}}\right)\cdot\frac{\sqrt{3}\pi}{3}m_2$$

$$\dots (9).$$

In the example illustrated in Fig. 15B, the distance s between the lattice point and the actual center of gravity of the modified refractive index area 352 is the same at all lattice points, and the direction of the shift (shifted azimuth angle) is modulated. However, as illustrated in Fig. 18, the direction of the shift may be the same (x direction) at all lattice points, and the distance s may be determined so as to satisfy s = $s_{\text{max}}$cos$\Psi$ by the modulation phase $\Psi$. In this case, |s| is modulated between zero and a maximum value $s_{\text{max}}$. Similarly to the example illustrated in Fig. 15B, the modulation phase $\Psi$ can be set to a different value by setting the angle $\theta$ to a different value depending on the lattice point. By the above, by moving a position of the electric current flow region to the active layer and, by this, moving a position of the light amplification region, an angle of an emitted laser beam can be changed, and, by this, scanning with the laser beam can be performed.

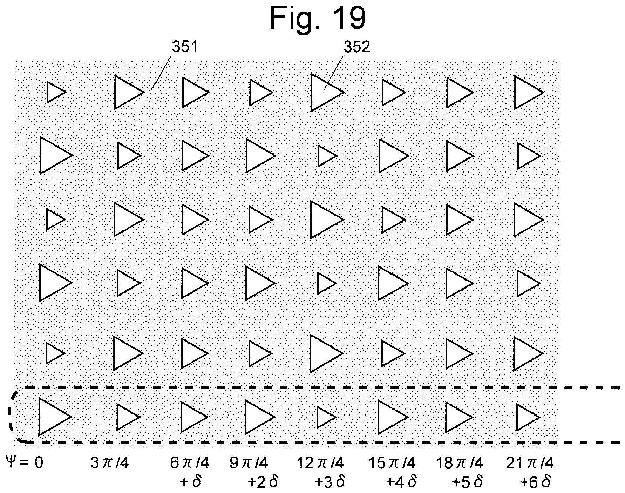

Alternatively, as illustrated in Fig. 19, after the center of gravity of the modified refractive index area 352 is arranged at the lattice point of the basic two-dimensional lattice, an area S of a planar shape of each of the modified refractive index areas 352 may be determined so as to satisfy S = $S_0$ + S'cos$\Psi$ by the modulation phase $\Psi$. In this case, the area S is modulated between a minimum value ($S_0$ - S') and a maximum value ($S_0$ + S'). Similarly to the example illustrated in Fig. 15B, the modulation phase $\Psi$ can be set to a different value by setting the angle $\theta$ to a different value depending on the lattice point. By the above, by moving a position of the electric current flow region to the active layer and, by this, moving a position of the light amplification region, scanning with an emitted laser beam can be performed.

As described in Patent Literature 3, in a case of using the modulation phase $\Psi(x, y)$ obtained from the reciprocal lattice vector G'(x, y)↑ depending on a position in the two-dimensional photonic-crystal layer, specifically, the modulation phase $\Psi(x, y)$ can be obtained as described below. For example, in a case where the basic two-dimensional lattice is a square lattice having the lattice constant a, each of the components g'$_x$(x) and g'$_y$(y) of the reciprocal lattice vector G'(x, y)↑ is

[Equation 10]

$$g'_x(x) = \pm \left( \frac{1}{2} \pm \frac{\sin \theta_x(x)}{\sqrt{2} n_{\text{eff}}} \right) \cdot \frac{2\pi}{a}$$

$$g'_y(y) = \pm \left( \frac{1}{2} \pm \frac{\sin \theta_y(y)}{\sqrt{2} n_{\text{eff}}} \right) \cdot \frac{2\pi}{a}$$

$$\dots (10).$$

Here, in a plurality of double signs in Equation (10), a combination of positive and negative signs is optional. As an example, in a case where all the double signs in Equation (10) are positive, the modulation phase $\Psi(x, y)$ is calculated by using Equation (1) as follows:

[Equation 11]

$$\Psi(x, y) = \frac{2\pi}{a} \left( \frac{x}{2} + \frac{y}{2} - \frac{\cos \theta_x(x)}{\theta'_x(x) \cdot \sqrt{2} n_{\text{eff}}} - \frac{\cos \theta_y(y)}{\theta'_y(y) \cdot \sqrt{2} n_{\text{eff}}} \right)$$

$$\dots (11).$$

Here, $\theta'_x$(x) and $\theta'_y$(y) are a first-order differential of $\theta_x$(x) and $\theta_y$(y), respectively. The same applies a case where a combination of positive and negative signs of a double sign is other than the above.

Using the modulation phase $\Psi(x, y)$ thus obtained, at each lattice point in the two-dimensional photonic-crystal, the direction and magnitude of the shift of the position of the modified refractive index area from the lattice point, the area of the modified refractive index area, or the like is preferably modulated in the same manner as in the examples illustrated in Figs. 15 to 19 according to a position (x, y) of the lattice point.

In particular, by applying the example illustrated in Fig. 17, different inclination angles θ (x, y) and/or azimuth angles φ (x, y) are preferably set for each of the shifted azimuth angle setting regions 231, 232, 233, ..., and the same inclination angles θ (x, y) and azimuth angles φ (x, y) are preferably set in the same shifted azimuth angle setting regions 231, 232, 233, .... By the above, by supplying electric current so that one of the shifted azimuth angle setting regions 231, 232, 233, ... becomes the light amplification region, a laser beam having the inclination angle θ(x, y) and the azimuth angle φ(x, y) set in the shifted azimuth angle setting region can be obtained. In Fig. 17, the direction of the shift of the position of the modified refractive index area from the lattice point is modulated, but the same applies to a case where modulation is performed using other parameters such as the magnitude of the shift and the area of the modified refractive index area.

Even in a case where the basic two-dimensional lattice is another two-dimensional lattice such as a rectangular lattice or a triangular lattice, the modulation phase $\Psi(x, y)$ can be obtained from the reciprocal lattice vector G'(x, y)↑ depending on a position in the two-dimensional photonic-crystal layer by similar calculation.

Also in the two-dimensional photonic-crystal laser 2, similarly to the two-dimensional photonic-crystal laser 1, instead of the reflection layer 17, a distributed Bragg reflector may be provided between the two-dimensional photonic-crystal layer 15 and the partial electrode 1811.

Those skilled in the art can understand that further variations can be made by combining the variation of the second embodiment described above.

The present invention is not limited to the first embodiment, the second embodiment, and the variation, and further modification is also possible.

REFERENCE SIGNS LIST

1, 1A, 1B, 2... Two-Dimensional Photonic-Crystal Laser
10, 30... Layered Body
11, 11A, 11B... Substrate
121... First Cladding Layer
122... Second Cladding Layer
13... Active Layer
14... Carrier Block Layer
15, 35... Two-Dimensional Photonic-Crystal Layer
151, 351... Base Body
152, 152A, 352... Modified Refractive Index Area
1521... First Partial Modified Refractive Index Area
1522... Second Partial Modified Refractive Index Area
16... Contact Layer
181... First Electrode
1811... Partial Electrode
1811A... Partial Electrode Group
182... Second Electrode
1821... Frame-Shaped Portion
1822... Window Portion
19, 19A, 19B... Lens
21... Electric Current Supplying Region
22... Electric Current Flow Region
221... Partial Electric Current Flow Region
231... Azimuth Angle Setting Region
352V... Modified Refractive Index Area Virtually Arranged
91, 91A... Switch
92... DC Power Supply

**Claims**

1. A two-dimensional photonic-crystal laser formed by sandwiching, between a first electrode and a second electrode, a layered body including an active layer and a two-dimensional photonic-crystal layer in which modified refractive index areas having a refractive index different from a refractive index of a plate-shaped base body are periodically arranged two-dimensionally in the base body, wherein

the first electrode is divided into a plurality of partial electrodes, and
the second electrode is a frame-shaped electrode including a frame-shaped portion made of a conductor, the second electrode having a window portion which is a space inside the frame-shaped portion being arranged to face a region enclosing the plurality of partial electrodes,
the two-dimensional photonic-crystal laser comprising:
a lens provided on a side opposite to the layered body of the second electrode or on a surface of the layered body on the second electrode side in a manner covering the window portion.

2. The two-dimensional photonic-crystal laser according to claim 1, wherein the lens is formed integrally with the layered body on the surface of the layered body on the second electrode side.

3. The two-dimensional photonic-crystal laser according to claim 1 or 2, wherein
an interval between adjacent partial electrodes is set such that a partial electric current flow region, which is a region in the active layer where electric current is supplied from one of the plurality of partial electrodes, overlaps a part of a partial electric current flow region in the active layer where electric current is supplied from a partial electrode adjacent to the partial electrode.

4. The two-dimensional photonic-crystal laser according to any of claims 1 to 3, wherein the lens is placed away from the two-dimensional photonic-crystal layer by a distance 0.5 to 2 times a focal length of the lens.

5. The two-dimensional photonic-crystal laser according to any of claims 1 to 4, wherein in the lens, one of or both of a surface curvature and focal length are variable.

6. The two-dimensional photonic-crystal laser according to any of claims 1 to 5, wherein

in the two-dimensional photonic-crystal layer,
the modified refractive index area includes two partial modified refractive index areas, and
a shape of the two partial modified refractive index areas is set so that $|\kappa_{180} + \kappa_{90}|$, which is an absolute value of a difference between a coupling coefficient $\kappa_{180}$ of 180° diffracted light obtained as light propagating in the two-dimensional photonic-crystal layer is diffracted by the modified refractive index area in a 180° direction and a coupling coefficient $-\kappa_{90}$ of 90° diffracted light obtained as light propagating in the two-dimensional photonic-crystal layer is diffracted by the modified refractive index area in a 90° direction is 100 cm$^{-1}$ or less.

7. The two-dimensional photonic-crystal laser according to any of claims 1 to 6, further comprising a reflection portion between the plurality of partial electrodes, wherein the reflection portion is made of an electrically insulating material and configured to reflect a laser beam.

8. A two-dimensional photonic-crystal laser formed by sandwiching, between a first electrode and a second electrode, a layered body including an active layer and a two-dimensional photonic-crystal layer in which modified refractive index areas having a refractive index different from a refractive index of a plate-shaped base body are arranged two-dimensionally on the base body, wherein

the first electrode is divided into a plurality of partial electrodes,
the second electrode is a frame-shaped electrode including a frame-shaped portion made of a conductor, the second electrode having a window portion which is a space inside the frame-shaped portion being arranged to face a region enclosing the plurality of partial electrodes,
in the two-dimensional photonic-crystal layer, each of the modified refractive index areas is arranged by being modulated by a predetermined modulation phase $\Psi$ at each lattice point of a basic two-dimensional lattice having periodicity determined so as to form a resonance state with a wavelength $\lambda_L$ by forming a two-dimensional standing wave and not to emit light with the wavelength $\lambda_L$ to outside, and
the modulation phase $\Psi$ is expressed by $\Psi = \vec{r} \cdot \vec{G'}$ using a wavevector $\vec{k} = (k_x, k_y)$ of light having the wavelength $\lambda_L$ in the two-dimensional photonic-crystal layer, an effective refractive index $n_{eff}$ of the two-dimensional photonic-crystal layer, a predetermined angle $\theta$, a reciprocal lattice vector $\vec{G'} = (g'_x, g'_y) = (k_x \pm |\vec{k}|(\sin\theta\cos\phi)/n_{eff}, k_y \pm |\vec{k}|(\sin\theta\sin\phi)/n_{eff})$ expressed using an azimuth angle $\phi$ from a predetermined reference line of the basic two-dimensional lattice, and a position vector rT of each lattice point, and the angle $\theta$ differs depending on a position in the two-dimensional photonic-crystal layer.

9. The two-dimensional photonic-crystal laser according to claim 8, wherein

the reciprocal lattice vector $\vec{G'}$ is expressed by a function $\vec{G'(x, y)} = (g'_x(x), g'_y(y)) = (k_x \pm |\vec{k}|\sin\theta_x(x)/n_{eff}, k_y \pm |\vec{k}|\sin\theta_y(y)/n_{eff})$ of a position (x, y) in the two-dimensional photonic-crystal layer using $\sin\theta_x(x) = \sin\theta(x, y)\cos\phi(x, y)$ and $\sin\theta_y(y) = \sin\theta(x, y)\sin\phi(x, y)$ represented by an inclination angle $\theta(x, y)$ and an azimuth angle $\phi(x, y)$ of a laser beam to be emitted from the position, and
the modulation phase $\Psi$ is defined by a function of the position which is
[Equation 1]

$$\Psi(x, y) = \int G'(x, y)\, \mathrm{d}x\mathrm{d}y$$

...(1).

10. The two-dimensional photonic-crystal laser according to claim 8 or 9, wherein an interval between adjacent partial electrodes is set such that a partial electric current flow region, which is a region in the active layer where electric current is supplied from each of the plurality of partial electrodes, overlaps a part of a partial electric current flow region in the active layer where electric current is supplied from a partial electrode adjacent to the partial electrode.

11. The two-dimensional photonic-crystal laser according to any of claims 8 to 10, further comprising a reflection portion between the plurality of partial electrodes, wherein the reflection portion is made of an electrically insulating material and configured to reflect a laser beam.

# Fig. 1

# Fig. 2

# Fig. 3

152
1522
1521
151
15

# Fig. 4

152A
151

# Fig. 5A

1811

17

# Fig. 5B

1811

17

# Fig. 6A

# Fig. 6B

22 IS MOVED

# Fig. 7A

# Fig. 7B

22 IS MOVED

INCIDENT POSITION IS
CHANGED TO 19

LB ANGLE IS CHANGED

# Fig. 8

22 IS MOVED

$L_{LP}$
$=f$

13
11

1821
1822
19

LB

LB SCANNING

# Fig. 9

1811A

21          91A

221
=22

221
=22

221
=22

15
13

# Fig. 10A

# Fig. 10B

## Fig. 10C

$w_e = 3.819d + 14.309$

DISTANCE FROM DIVIDED ELECTRODE END PORTION WHERE $i_1/i_0 = 1/e^2$ We [μm]

DEPTH FROM DIVIDED ELECTRODE d [μm]

## Fig. 11

# Fig. 12A

# Fig. 12B

# Fig. 12C

# Fig. 13A

# Fig. 13B

# Fig. 14

# Fig. 15A

352   352V   351

a

35

a

x
(DIRECTION OF
REFERENCE LINE)

# Fig. 15B

$\Delta \Psi_y = \pi$

y

a

a

s

$\pi$

$7\pi/4$

$\Psi$   $\Psi$   $\Psi$

$\Delta \Psi_x = 3\pi/4 + 3\delta$

$\Delta \Psi_x = 3\pi/4 + 2\delta$

$\Delta \Psi_x = 3\pi/4$

$\Delta \Psi_x = 3\pi/4 + \delta$

x
(DIRECTION OF
REFERENCE LINE)

# Fig. 16A

# Fig. 16B

# Fig. 17

x (DIRECTION OF REFERENCE LINE)

231    232    233

$\Delta\Psi_x = 3\pi/4$    $\Delta\Psi_x = 3\pi/4$

$\Delta\Psi_x = 3\pi/4 + \delta$    $\Delta\Psi_x = 3\pi/4 + \delta$

$\pi$    $7\pi/4$

# Fig. 18

$\Psi = 0$    $3\pi/4$    $6\pi/4 + \delta$    $9\pi/4 + 2\delta$    $12\pi/4 + 3\delta$    $15\pi/4 + 4\delta$    $\bullet\bullet\bullet$

S = S$_{max}$

x (DIRECTION OF REFERENCE LINE)

# Fig. 19

$\Psi = 0$   $3\pi/4$   $6\pi/4$   $9\pi/4$   $12\pi/4$   $15\pi/4$   $18\pi/4$   $21\pi/4$
$+\delta$   $+2\delta$   $+3\delta$   $+4\delta$   $+5\delta$   $+6\delta$

**INTERNATIONAL SEARCH REPORT**

| International application No. |
| --- |
| PCT/JP2021/013620 |

**A. CLASSIFICATION OF SUBJECT MATTER**
H01S 5/18(2021.01)i
FI: H01S5/18
According to International Patent Classification (IPC) or to both national classification and IPC

**B. FIELDS SEARCHED**

Minimum documentation searched (classification system followed by classification symbols)
H01S5/00-5/50

Documentation searched other than minimum documentation to the extent that such documents are included in the fields searched
| | |
| --- | --- |
| Published examined utility model applications of Japan | 1922-1996 |
| Published unexamined utility model applications of Japan | 1971-2021 |
| Registered utility model specifications of Japan | 1996-2021 |
| Published registered utility model applications of Japan | 1994-2021 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| X | WO 2014/136607 A1 (JAPAN SCIENCE AND TECHNOLOGY | 8-10 |
| Y | AGENCY) 12 September 2014 (2014-09-12) paragraphs | 1-4 |
| A | [0034]-[0050], fig. 2-4, 10-11 | 5-7, 11 |
| Y | JP 2005-277219 A (KYOTO UNIVERSITY) 06 October 2005 (2005-10-06) paragraphs [0036], [0040], fig. 6 | 1-4 |
| A | JP 2001-13306 A (CANON INC.) 19 January 2001 (2001-01-19) entire text, all drawings | 1-11 |
| A | JP 2017-123445 A (HAMAMATSU PHOTONICS K.K.) 13 July 2017 (2017-07-13) entire text, all drawings | 1-11 |
| A | JP 2014-82257 A (KYOTO UNIVERSITY) 08 May 2014 (2014-05-08) entire text, all drawings | 1-11 |
| A | US 6026111 A (MOTOROLA, INC.) 15 February 2000 (2000-02-15) entire text, all drawings | 1-11 |

☐ Further documents are listed in the continuation of Box C.      ☒ See patent family annex.

| | |
| --- | --- |
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| 28 May 2021 (28.05.2021) | 08 June 2021 (08.06.2021) |

| Name and mailing address of the ISA/ | Authorized officer |
| --- | --- |
| Japan Patent Office 3-4-3, Kasumigaseki, Chiyoda-ku, Tokyo 100-8915, Japan | |
| | Telephone No. |

Form PCT/ISA/210 (second sheet) (January 2015)

**INTERNATIONAL SEARCH REPORT**
Information on patent family members

| International application No. |
|---|
| PCT/JP2021/013620 |

| Patent Documents referred in the Report | Publication Date | Patent Family | Publication Date |
|---|---|---|---|
| WO 2014/136607 A1 | 12 Sep. 2014 | US 2016/0248224 A1 paragraphs [0087]-[0104], fig. 2-4, 10-11<br>EP 2966737 A1<br>CN 105191029 A | |
| JP 2005-277219 A | 06 Oct. 2005 | (Family: none) | |
| JP 2001-13306 A | 19 Jan. 2001 | (Family: none) | |
| JP 2017-123445 A | 13 Jul. 2017 | US 2017/0201069 A1<br>DE 102017200061 A1 | |
| JP 2014-82257 A | 08 May 2014 | (Family: none) | |
| US 6026111 A | 15 Feb. 2000 | (Family: none) | |

Form PCT/ISA/210 (patent family annex) (January 2015)

**EP 4 131 675 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2005277219 A
- WO 2014136607 A
- US 20160248224 A
- JP 2008243962 A